# EUROPEAN PATENT SPECIFICATION

(11) **EP 1 998 360 B1**
(45) Date of publication and mention of the grant of the patent: **01.10.2014**
(21) Application number: 08015658.1
(22) Date of filing: 06.05.2004
(51) Int. Cl.: H01L 21/673

(54) **Lid unit for thin plate supporting container**
Deckelvorrichtung für einen Dünnplattenbehälter
Dispositif de couvercle pour un récipient de plaques minces

(30) Priority: 19.05.2003 JP 2003140402; 05.09.2003 JP 2003314640
(43) Date of publication of application: 03.12.2008
(62) Divisional of application: 04010798.9
(73) Proprietor: Miraial Co., Ltd., Toshima-ku Tokyo 170-0013 (JP)
(72) Inventor: Matsutori, Chiaki, Shisui-machi Kikuchi-gun Kumamoto-ken (JP); Obayashi, Tadahiro, Shisui-machi Kikuchi-gun Kumamoto-ken (JP); Oyama, Takaharu, Shisui-machi Kikuchi-gun Kumamoto-ken (JP)
(74) Representative: Grünecker, Kinkeldey, Stockmair & Schwanhäusser

(56) References cited:
- EP-A- 1 538 662
- WO-A-90/14273
- WO-A1-00/02798
- GB-A- 2 290 414
- US-A- 5 555 981
- US-A- 6 082 540
- US-A1- 2002 106 266
- US-A1- 2003 047 476

## Description

### BACKGROUND OF THE INVENTION

### Field of the Invention

The present invention relates to a lid unit for a thin plate supporting container for housing a thin plate such as a semiconductor wafer, a storage disk, or a liquid crystal glass substrate so as to be used in a storing, transporting, or manufacturing process or the like.

### Related Background Art

A thin plate supporting container for housing a thin plate such as a semiconductor wafer so as to be stored or transported is generally known.

The thin plate supporting container is constructed mainly by a container body and a lid unit for closing the upper opening of the container body. In the container body, a member for supporting a thin plate such as a semiconductor wafer is provided. Such a thin plate supporting container has to be transferred while maintaining the inside of the container clean in order to prevent soiling of the surface of the thin plate such as a semiconductor wafer housed inside. Consequently, the container is sealed. To be specific, a lid unit is fixed on the container body to airtightly seal the container body. There are various structures for fixing the lid unit on the container body.

The thin plate supporting container transported to a semiconductor manufacturing factory or the like is placed on a manufacturing line and the lid unit is automatically taken off by a dedicated apparatus.

An example of the lid unit adapted to the dedicated apparatus is disclosed in Japanese Patent Application Laid-Open No. 2001-512288. A lid unit 1 is constructed by, as shown in FIG. 2, a body 2, a cam member 3, a latch arm, and a fulcrum 5.

The cam member 3 is rotatably attached to the body 2. In the cam member 3, a cam portion 6 is provided. In the cam portion 6, a coupling opening 7 having an arched elongated hole shape is provided.

At the base end of the latch arm 4, an S-shaped cam follower 8 is provided. The S-shaped cam follower 8 is fit and caught in the coupling opening 7.

The fulcrum 5 is a projection member provided for the body 2 and supports the latch arm 4.

With the structure, when the cam member 3 rotates, the S-shaped cam follower 8 caught in the coupling opening 7 is lifted upward while being moved to the right side in the diagram. Consequently, the latch arm 4 swings around the fulcrum 5 as a center while being projected from the body 2 and the tip of the latch arm 4 is pressed downward.

At this time, the tip of the latch arm 4 is fit in a hole on the container body side. By being pressed downward, the tip of the latch arm 4 presses the lid unit against the container body side so as to be fixed.

However, since the lid unit 1 has the configuration that the base end of the latch arm 4 is lifted upward while being captured by the cam member 3 and projected, thereby swinging the latch arm 4 around the fulcrum 5 as a center, in the sense of the action of a lever, the base end of the latch arm 4 is the power point, the tip is the point of application, and the fulcrum 5 is the fulcrum.

In this case, to press the lid unit 1 strongly against the container body in order to increase air tightness in the container body, it is necessary to strongly press the tip of the latch arm 4 against the hole portion on the container body.

To realize it, the strength of the cam member 3 and the latch arm 4 has to be increased for the reason that the interval between the tip of the latch arm 4 and the fulcrum 5 is long. In this case, by moving the fulcrum 5 toward the tip of the latch arm 4, the tip of the latch arm 4 can be strongly pressed against the hole portion on the container body side without increasing the strength of the cam member 3 and the latch arm 4.

However, when the fulcrum 5 is moved toward the tip side, the distance required to lift the base end of the latch arm 4 upward becomes longer. If the distance to lift is assured, a problem occurs such that the lid unit 1 becomes thick.

On the rear face of the lid unit, a wafer presser is usually provided. The wafer presser supports a semiconductor wafer housed in the container body by pressing the semiconductor wafer from above. As the diameter of a semiconductor wafer increases, the power of supporting the semiconductor wafer has to be also increased. Accordingly, repulsion from the semiconductor wafer, which is received by the wafer presser increases. Also when the number of semiconductor wafers housed increases, repulsion from the semiconductor wafers increases. As a result, the lid unit and the wafer presser are deflected to the outside by the repulsion and the pressing force in the center portion of the wafer presser is weakened. It causes a problem such that, when vibration is transmitted from the outside, the semiconductor wafer rotates. WO 00/02798 A1 discloses a cushioned wafer container according to the prior art.

### SUMMARY OF THE INVENTION

The present invention has been achieved in consideration of the above problems and its object is to provide a lid unit for a thin plate supporting container capable of firmly supporting a thin plate with strong force without increasing the size and preventing a thin plate from rotating even when vibration is transmitted from the outside.

According to the invention, there is provided a lid unit for a thin plate supporting container for closing a container body of a thin plate supporting container in which a plurality of thin plates are housed and which is carried, including a thin plate presser for supporting thin plates housed in the container body, the thin plate presser including: two base-end supporting portions fixed to a rear surface side of the lid unit; a plurality of contact pieces which are disposed along the periphery of the thin plate and come into direct contact with the thin plate; two elastic supporting plates supported by the base-end supporting portions and each supporting an outer end of each of contact pieces at both ends among the plurality of contact pieces; a connecting and supporting plate for connecting and supporting the contact pieces; and characterized by a supporting member for preventing a deviation of the connecting and supporting plate along the rear surface of the lid unit while permitting fluctuations in the direction perpendicular to the rear surface of the lid unit, as described in claim 1.

With the structure, an outer end of each of contact pieces at both ends among the plurality of contact pieces is supported by the elastic supporting plate, the contact pieces are supported by the connecting and supporting plate, and the connecting and supporting plate is supported by the supporting member, thereby supporting the periphery of a thin plate by the contact pieces with reliability. Particularly, the contact pieces are supported by the connecting and supporting plate supported by the supporting member, so that each of the contact pieces can be prevented from being deviated along the rear surface of the lid unit, and a thin plate can be supported with reliability.

According to a preferred aspect of the invention, the supporting member has supporting ribs each for supporting each of the connecting and supporting plates so as not to be deviated along the rear surface of the lid unit.

With the structure, the supporting ribs support the connecting and supporting plates, so that the contact pieces can be prevented from being deviated along the rear surface of the lid unit, and a thin plate can be supported with reliability.

According to a favorable embodiment of the invention, the supporting member has a fitting projection which is fit in a fitting hole formed in the connecting and supporting plate, thereby preventing a deviation along the rear surface of the lid unit of the connecting and supporting plate while permitting fluctuations in a direction perpendicular to the rear surface of the lid unit.

With the structure, the fitting projection is fit into the fitting hole formed in the connecting and supporting plate to support the connecting and supporting plate. Thus, contact pieces can be prevented from being deviated along the rear surface of the lid unit, and a thin plate can be supported with reliability.

According to another aspect of the invention, elastic force for supporting the contact piece by the connecting and supporting plate is stronger than elastic force for supporting the contact piece by the elastic supporting plate.

With the structure, by making the elastic force for supporting the contact piece by the connecting and supporting plate strong, the difference between the elastic force (supporting force) in the center portion of the thin plate presser and that in the end portion is eliminated. The force of pressing thin plates can be wholly equalized and the thin plates can be supported with reliability.

As described above in detail, the lid unit for a thin plate supporting container of the invention produces the following effects.
(1) Since the locking member is projected by using the action of a lever, the lid unit for a manufacturing line can be fixed to the container body with strong force.
(2) Since the simple attaching/detaching mechanism can be easily disassembled to component parts, in the case of cleaning, the simple attaching/detaching mechanism can be detached and disassembled to component parts. Each of the component parts can be cleaned and promptly dried.
(3) Since the supporting pieces are disposed alternately, the supporting pieces alternately come into contact with the periphery of a thin plate and can support the periphery with reliability.
(4) The contact pieces are supported in such a manner that the contact piece in the center portion is projected to the thin plate side more than the contact pieces on both sides. Consequently, deflection of the lid unit can be absorbed and thin plates can be supported with uniform force.
(5) The elastic supporting plate supports so that the contact piece in the center portion is projected to the thin plate side more than the contact pieces on both sides among the contact pieces which are disposed in parallel. Thus, deflection of the lid unit can be absorbed and thin plates can be supported with uniform force.
(6) Since the one-side elastic supporting plate and/or the other-side elastic supporting plate support each of the contact pieces so that the contact piece positioned in the center portion is projected to the thin plate side more than the contact pieces positioned on both sides among the contact pieces disposed in parallel, deflection of the lid unit can be absorbed and each of thin plates can be supported with uniform force.
(7) The supporting projection bar and/or the other-side elastic supporting plate support each of the contact pieces so that the contact piece positioned in the center portion is projected to the thin plate side more than the contact pieces positioned on both sides among the contact pieces disposed in parallel. Thus, deflection of the lid unit can be absorbed and each of thin plates can be supported with uniform force.
(8) Since the connecting and supporting plate between the contact pieces is supported by the supporting member, each of the contact pieces can be prevented from being deviated along the rear surface of the lid unit, and the thin plate can be supported with reliability.
(9) Since the connecting and supporting plate is supported by the supporting ribs, the contact pieces can be prevented from being deviated along the rear surface of the lid unit, and a thin plate can be supported with reliability.
(10) Since the fitting projection is fit into the fitting hole formed in the connecting and supporting plate to support the connecting and supporting plate, contact pieces can be prevented from being deviated along the rear surface of the lid unit, and a thin plate can be supported with reliability.
(11) By making the elastic force for supporting the contact piece by the connecting and supporting plate strong, the difference between the supporting force in the center portion of the thin plate presser and that in the end portion is eliminated. The force of pressing thin plates can be equalized as a whole and the thin plates can be supported with reliability.

### BRIEF DESCRIPTION OF THE DRAWINGS

FIG. 1 is a partial perspective view showing a lid unit for a manufacturing line.

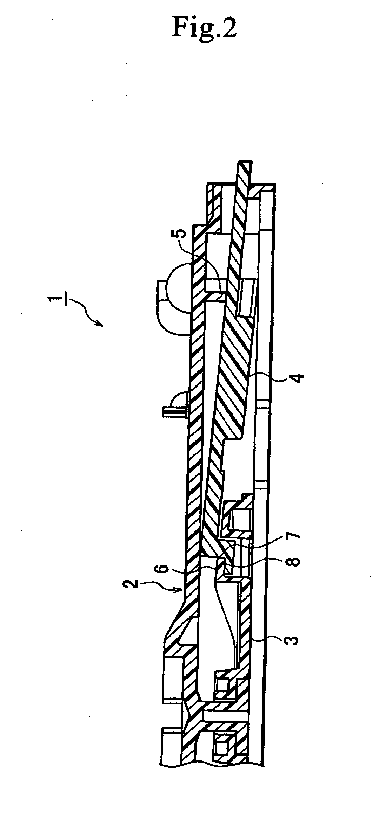

FIG. 2 is a sectional side elevation of a conventional lid unit for a thin plate supporting container.
FIG. 3 is a perspective view showing the thin plate supporting container.
FIG. 4 is a perspective view of the thin plate supporting container in a state where the lid unit is taken off.
FIG. 5 is a partial perspective view showing a lid unit receiving portion of the thin plate supporting container.
FIG. 6 is a partial cross section of the lid unit receiving portion of the thin plate supporting container.
FIG. 7 is a perspective view showing the top face of a lid unit for a manufacturing line.
FIG. 8 is a perspective view showing the under face of the lid unit for the manufacturing line.
FIG. 9 is a perspective view showing the top face of a locking member.
FIG. 10 is a perspective view showing the under face of the locking member.
FIG. 11 is a sectional side view showing the locking member.
FIG. 12 is a perspective view showing the top face of a feeding member.
FIG. 13 is a perspective view showing the back face of the feeding member.
FIG. 14 is a plan view showing the feeding member.
FIG. 15 is a diagram showing the back face of the feeding member.
FIG. 16 is a perspective view showing the top face of a holding cover.
FIG. 17 is a perspective view showing the back face of the holding cover.
FIG. 18 is a perspective view showing the top face of a cover presser.
FIG. 19 is a perspective view showing the top face of the cover presser.
FIG. 20 is a side view showing a wafer presser.
FIG. 21 is a perspective view showing the wafer presser.
FIG. 22 is a perspective view showing the wafer presser.
FIG. 23 is a perspective view showing a lid unit holder.
FIGS. 24A to 24D are schematic diagrams showing the operation of a simple attaching/detaching mechanism.
FIG. 25 is a side view showing the wafer presser according to a first modification.
FIG. 26 is a perspective view showing the wafer presser according to the first modification.
FIG. 27 is a perspective view showing the wafer presser according to the first modification.
FIG. 28 is a perspective view showing the wafer presser according to a second modification.
FIG. 29 is a front view showing the wafer presser according to the second modification.
FIG. 30 is a perspective view showing the wafer presser according to a third modification.
FIG. 31 is a cross section of a main portion showing the wafer presser according to the third modification.
FIG. 32 is a perspective view showing a wafer presser according to a fourth modification.
FIG. 33 is a front view showing the wafer presser according to the fourth modification.
FIG. 34 is a perspective view of a main portion of the wafer presser according to an embodiment of the invention.
FIG. 35 is a perspective view showing the back face of the lid unit including the wafer presser according to the embodiment of the invention.
FIG. 36 is a partial perspective view showing the back face of the lid unit including the wafer presser according to the embodiment of the invention.
FIG. 37 is a perspective view of a main portion showing the back face of the lid unit according to the embodiment of the invention in a state where the wafer presser is removed.
FIG. 38 is a partial perspective view showing the back face of the lid unit according to the embodiment of the invention in a state where the wafer presser is removed.
FIG. 39 is a perspective view showing a section of a supporting rib according to the embodiment of the invention.
FIG. 40 is an enlarged view of a main portion showing the wafer presser according to the embodiment of the invention.
FIG. 41 is an enlarged view of a main portion showing a contact piece of the wafer presser according to the embodiment of the invention.
FIG. 42 is an enlarged view of a main portion showing the contact piece of the wafer presser according to the embodiment of the invention.
FIG. 43 is a cross section of a main portion of the contact piece of the wafer presser according to the embodiment of the invention.
FIG. 44 is a perspective view of a main portion showing a modification of the embodiment of the invention.

### DETAILED DESCRIPTION OF THE PREFERRED EMBODIMENT

Embodiment of the invention will be described hereinbelow with reference to the appended drawings. A thin plate supporting container of the invention is a container for housing thin plates such as a semiconductor wafer, a storage disk, and a liquid crystal glass substrate so as to be used for storage, transport, manufacturing line, and the like. A thin plate supporting container for housing semiconductor wafers will be described here as an example. Lid units for closing a thin plate supporting container are properly used as a lid unit for transport and a lid unit for use in a manufacturing line.

### Example

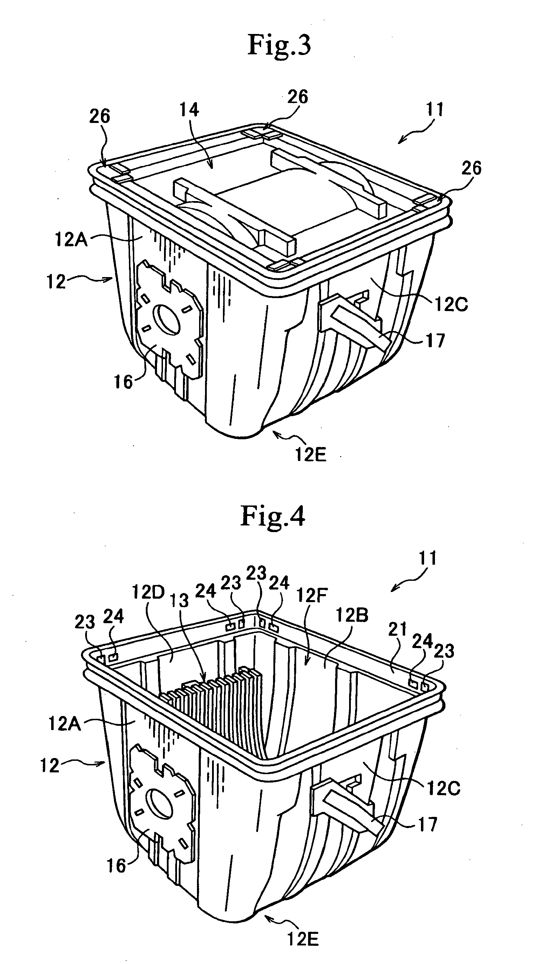

A thin plate supporting container 11 has, as shown in FIGS. 3 to 8, a container body 12 for housing therein a plurality of semiconductor wafers (not shown), two thin plate supporting portions 13 provided on opposite side walls in the container body 12 and supporting housed semiconductor wafers from both sides, a lid unit 14 for transport and a lid unit 15 for a manufacturing line, each for covering the container body 12, a top flange 16 held by an arm of a transporting apparatus (not shown) in a factory, and a handle 17 for carry which is grasped by a worker when the worker carries the thin plate supporting container 11.

The container body 12 is formed in an almost cube shape as shown in FIGS. 3 and 4. The container body 12 is constructed by four side walls 12A, 12B, 12C, and 12D serving as peripheral walls and a bottom plate 12E when the container body 12 is set in the portrait orientation, and an opening 12F is provided at the top of the container body 12. When the container body 12 is installed so as to face a robot (not shown) for carrying wafers in a manufacturing line of semiconductor wafers or the like, it is set in the landscape orientation. On the outside of the side wall 12A, which serves as the bottom when the supporting container 11 is set in the landscape orientation, means (not shown) for positioning the thin plate supporting container 11 is provided. The top flange 16 is detachably attached to the outside of the side wall 12A serving as the ceiling when the supporting container 11 is set in the landscape orientation. To the outside of the side walls 12C and 12D serving as side walls when the supporting container 11 is set in the landscape orientation, the handles 17 for carry are detachably attached.

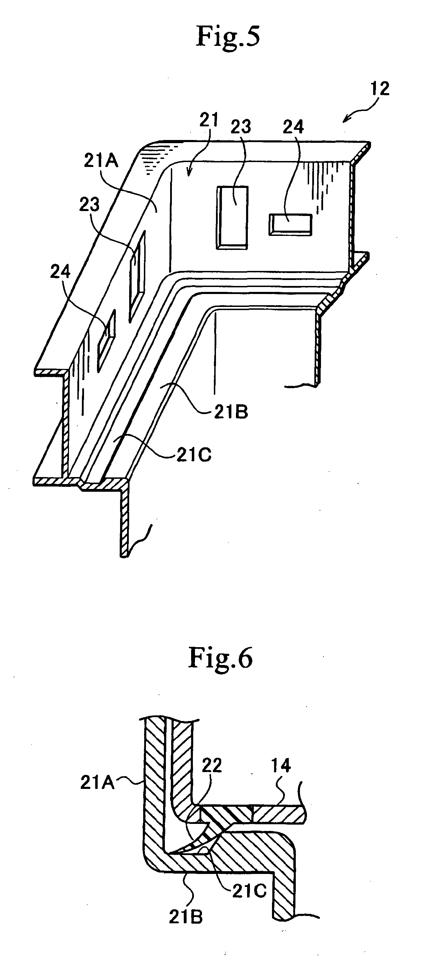

In the upper ends of the side walls 12A, 12B, 12C, and 12D of the container body 12, a lid unit receiving portion 21 to which the lid unit 14 is fit is provided as shown in FIGS. 5 and 6. The lid unit receiving portion 21 is formed by expanding the upper end portion of the container body 12 to the dimension of the lid unit 4. Consequently, the lid unit 4 is attached to the lid unit receiving portion 21 by being fit in a vertical plate portion 21A of the lid unit receiving portion 21 and coming into contact with a horizontal plate portion 21 B. Further, a seal groove 21 C is provided in the whole circumference of the horizontal plate portion 21 B, and a gasket 22 attached to the under face of the lid unit 14 for transport is fit in the seal groove 21 C, thereby keeping air tightness in the thin plate supporting container 11. In the inner face of the vertical plate portion 21A at the four corners of the lid unit receiving portion 21, first fitting portions 23 in which lid unit locking pawls (not shown) of a simple attaching/detaching mechanism 26 to be described later are fit, thereby fixing the lid unit 14 for transport to the container body 12 side are provided. The first fitting portion 23 is formed by forming a dent in a square shape in the vertical plate portion 21 A. The lid unit locking pawls are fit in the top face on the inner side of the first fitting portion 23.

Further, near each of the first fitting portions 23, a second fitting portion 24 is provided. The second fitting portion 24 is used for the manufacturing line. In the second fitting portion 24, a locking member 42 of a simple attaching/detaching mechanism 32 of the lid unit 15 for the manufacturing line is fit, thereby fixing the lid unit 15 for the manufacturing line to the container body 12 side.

The lid unit 14 for transport is a known lid unit. The lid unit 14 for transport is formed in a saucer shape and its center portion is formed as swelling in a cylindrical shape so as not to come into contact with the upper portion of a semiconductor wafer housed therein.

At each of the four corners of the lid unit 14 for transport, as shown in FIGS. 3 and 4, the simple attaching/detaching mechanism 26 for transport for detachably fixing the lid unit 14 for transport to the container body 12 is provided. The simple attaching/detaching mechanism 26 for transport is constructed mainly by including lid unit locking pawls (not shown) provided so as to be projected from the peripheral portion of the lid unit 14 for transport. The lid unit locking pawls are fit in the first fitting portions 23.

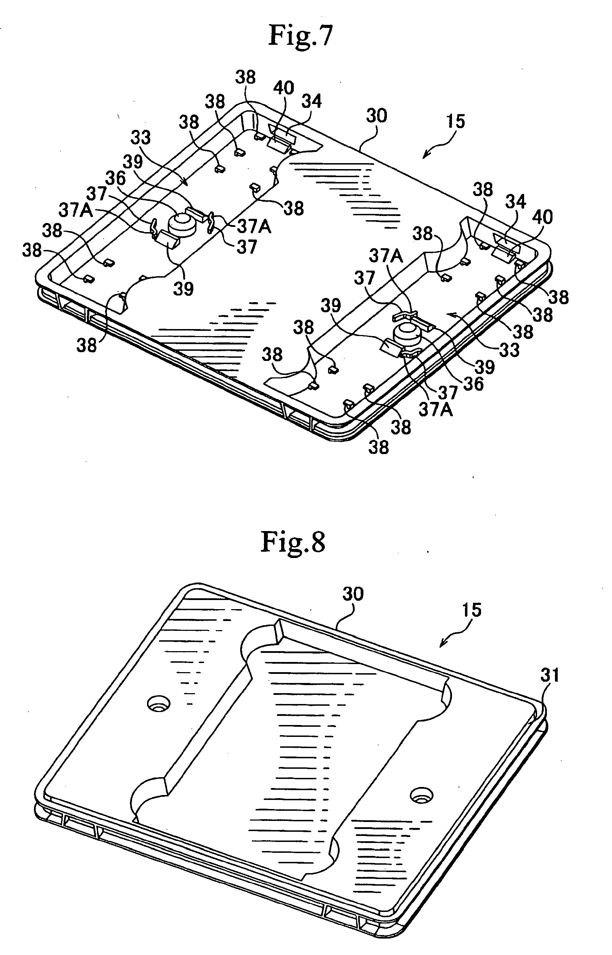

The lid unit 15 for the manufacturing line is a lid unit for enabling the container body 12 of the transported thin plate supporting container 11 to be used as it is for the manufacturing line in the factory. The lid unit 15 for the manufacturing line is placed in a semiconductor manufacturing factory or the like as a single product independent of the thin film supporting container 11. The lid unit 15 for the manufacturing line is constructed by, as shown in FIGS. 7 and 8, a body 30, a cover plate (not shown), and the simple attaching/detaching mechanism 32.

The body 30 is formed thinly in an almost square shape so as not to stick out in a state where it is attached to the lid unit receiving portion 21 of the container body 12. Around the lower portion of the body 30, a gasket receiving portion 31 is attached. A gasket (not shown) is provided for the gasket receiving portion 31. In a state where the body 30 is attached to the lid unit receiving portion 21, the gasket receiving portion 31 is fit in the seal groove 21C to seal the container body 12. The gasket is properly formed in accordance with the shape of the seal groove 21C in a manner similar to the gasket 22 of the lid unit 14 for transport.

At each of end portions on both sides in the longitudinal direction (both lower right and upper left) sides in FIG. 7) of the body 30 of the lid unit 15 for the manufacturing line, a recess 33 to which the simple attaching/detaching mechanism 32 is attached is formed. The recess 33 is formed by denting the end portion of the body 30 in an almost rectangular shape. At each of both end portions in the longitudinal direction of the recess 33 (both ends on the upper right and lower left) sides in FIG. 7), an opening 34 from which a tip fitting portion 56 of the locking member 42 to be described later projects is provided. The opening 34 is provided in a position corresponding to the position of the second fitting portion 24 in the lid unit receiving portion 21 in a state where the body 30 is fit in the lid unit receiving portion 21. On the bottom of the recess 33, a rotation supporting shaft 36, stoppers 37, locking pawls 38, base-end lower cams 39, and a tip-side cam 40 are provided. To the recess 33, a cover plate is detachably attached. The cover plate is detached at the time of cleaning the simple attaching/detaching mechanism 32 to be provided in the recess 33.

The rotation supporting shaft 36 is a member for rotatably supporting a feeding member 43 which will be described later. The rotation supporting shaft 36 is provided so as to be raised from the bottom in a cylindrical shape. The rotation supporting shaft 36 is fit in a rotation cylindrical portion 63 in the feeding member 43 and supports the feeding member 43 rotatably. The stopper 37 is a member for supporting the feeding member 43 in a state where the feeding member 43 is turned at a predetermined angle. The stopper 37 is constructed by plate-shaped members raised from the bottom in two positions around the rotation supporting shaft 36. By curving the plate-shaped members, receiving portions 37A are formed. By fitting a projection 65A of a engaging piece 65 of the feeding member 43 with the receiving portion 37A, the feeding member 43 is supported at a predetermined angle.

The locking pawl 38 is a member for fixing a cover presser 46, to be described later, to the bottom of the recess 33. The cover pressers 46 are provided on both sides in the longitudinal direction of the recess 33, so that six pieces of locking pawls 38 are attached on each of both sides in the longitudinal direction of the recess 33. The locking pawl 38 is a member having an L shape. A lower supporting plate piece 88 of the cover presser 46 fits with the locking pawl 38.

The base-end lower cam 39 and the tip-side cam 40 are members constructing a cam mechanism 44 to be described later. The base-end lower cam 39 and, to be described later, a base-end upper cam 53 construct a base-end-side cam for pressing the base-end side of the locking member 42 downward to make the locking member 42 project.

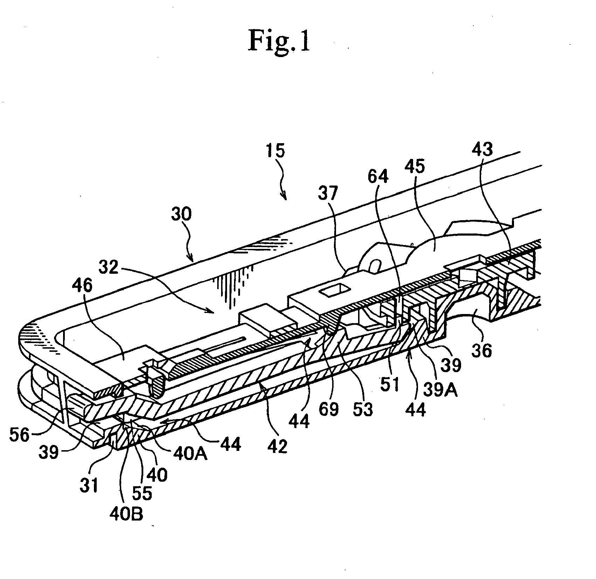

The base lower-side cam 39 is, as shown in FIGS. 1 and 7, a member for pressing the base-end side of the locking member 42 to the other side (downward in FIG. 1) to make the locking member 42 project. The base-end lower cams 39 are provided on both sides of the rotation supporting shaft 36. The base-end lower cam 39 is formed so that its side sectional shape is an almost triangle shape, and has an oblique surface 39A along which the base-end side of the locking member 42 is moved upward/downward. The oblique surface 39A is mirror-finished to reduce frictional resistance with a base-end-side sliding surface 52 of the locking member 42.

The tip-side cam 40 is a member for pressing (lifting) the tip fitting portion 56 of the locking member 42 to one side (upward in FIG. 1) in association with projection of the locking member 42. The tip-side cam 40 is provided at each of both ends in the longitudinal direction of the recess 33 so as to face the opening 34. The tip-side cam 40 is formed so that its side sectional shape is a triangle shape and has an oblique surface 40A for lifting the tip side of the locking member 42 upward. The oblique surface 40A is mirror-finished so as to reduce frictional resistance with a tip-side sliding face 55A of a fulcrum portion 55 of the locking member 42. At an upper end of the oblique surface 40A, a fitting recess 40B is provided. The fitting recess 40B is a portion in which the fulcrum portion 55 of the locking member 42 is fit.

In the recess 33, the simple attaching/detaching mechanism 32 is provided. The simple attaching/detaching mechanism 32 is a mechanism for enabling the lid unit 15 for the manufacturing line to be easily attached/detached to/from the container body 12. The simple attaching/detaching mechanism 32 is constructed by, as shown in FIG. 1, the locking member 42, the feeding member 43, the cam mechanism 44, a holding cover 45, and the cover presser 46.

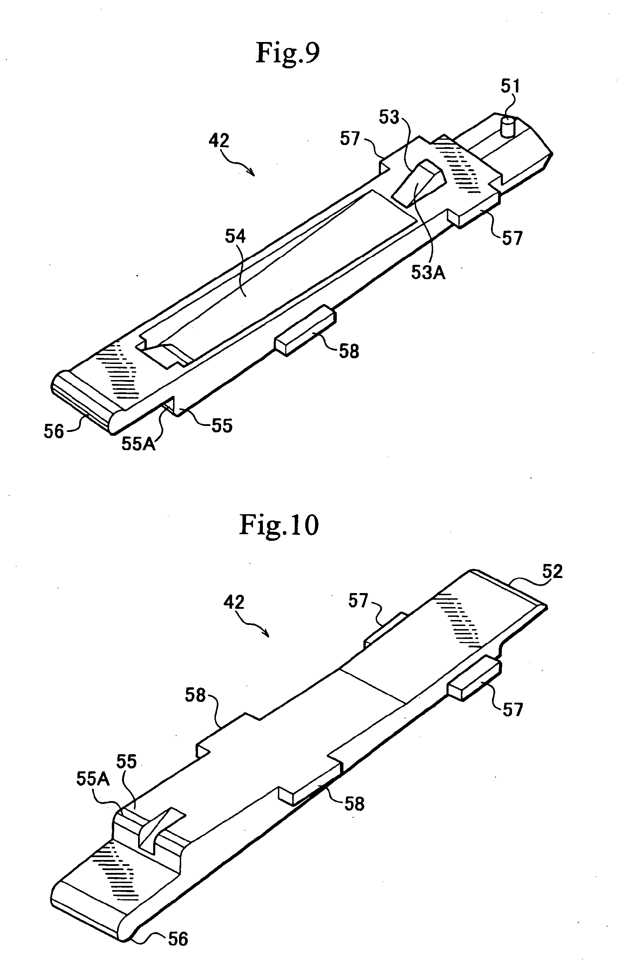

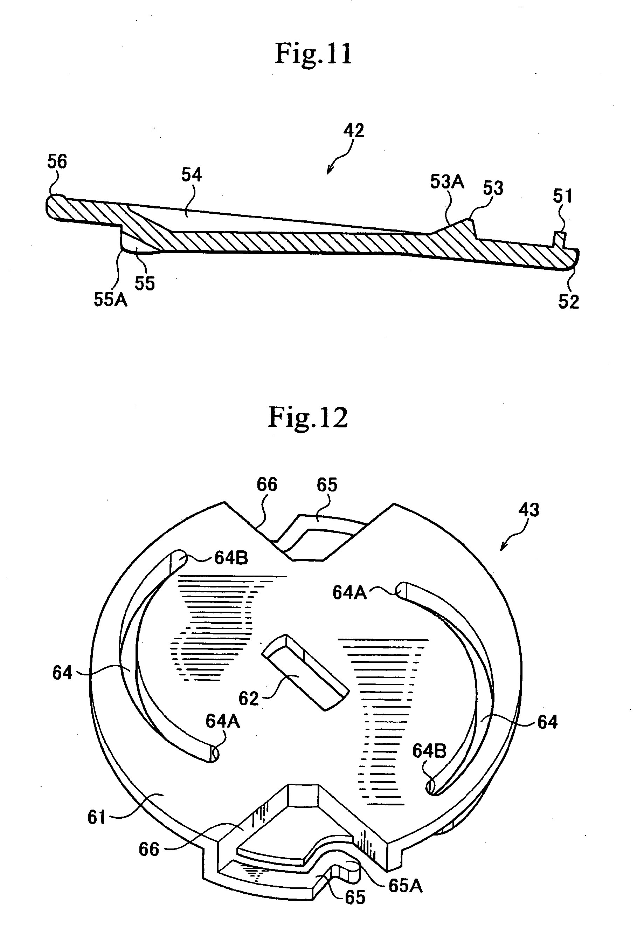

The locking member 42 is a member which is projected from the opening 34 in the body 30 and is fit into the second recess 24 in the lid unit receiving portion 21 in a state where the lid unit 15 for the manufacturing line is attached to the lid unit receiving portion 21 of the container body 12. The locking member 42 is constructed by, as shown in FIG. 1 and FIGS. 9 to 11, a coupling shaft 51, the base-end-side sliding surface 52, the base-end upper cam 53, an upper groove 54, the fulcrum portion 55, the tip fitting portion 56, a base-end side plate 57, and a tip side plate 58.

The coupling shaft 51 is a member which is fit into an arched elongated hole 64 in the feeding member 43 which will be described later, thereby coupling the feeding member 43 and the locking member 42 to each other. The coupling shaft 51 is formed in a round bar shape and provided in the base end portion of the locking member 42 so as to be directed upward.

The base-end-side sliding surface 52 is a portion which comes into slidable contact with the oblique surface 39A of the base-end lower cam 39 to vertically move the base end portion of the locking member 42. The base-end-side sliding surface 52 is formed by obliquely cutting a lower portion of the base end of the locking member 42. The base-end-side sliding surface 52 is mirror-finished to reduce frictional resistance with the oblique surface 39A of the base-end lower cam 39. When the locking member 42 is projected in a state where the base-end-side sliding surface 52 is in the slidable contact with the oblique surface 39A of the base-end lower cam 39, the base-end portion of the locking member 42 is pushed downward. When the locking member 42 is retracted, the base-end portion of the locking member 42 is pushed upward.

The base-end upper cam 53 is a portion for vertically moving the base-end portion of the locking member 42 in cooperation with the base-end lower cam 39. The base-end upper cam 53 is a portion serving as the power point in the action of a lever. The coupling shaft 51 does not serve as the power point in the action of a lever but is a portion for simply receiving the power in the longitudinal direction when the locking member 42 is projected/retracted.

The base-end upper cam 53 is provided near the base end portion of the locking member 42 so as to be directed upward. The base-end upper cam 53 is formed so that its side face sectional shape is a triangle shape and has an oblique surface 53A by which the base side of the locking member 42 is moved vertically. The oblique surface 53A of the base-end upper cam 53 is mirror-finished in a manner similar to the oblique surface 39A of the base-end lower cam 39 and is in slidable contact with a cam pressing projection 69 on the holding cover 45 side which will be described later. The oblique surface 53A of the base-end upper cam 53 is set so as to be almost parallel with the oblique surface 39A of the base-end lower cam 39. With the configuration, when the locking member 42 is projected in a state where the cam pressing projection 69 is in slidable contact with the oblique surface 53A of the base-end upper cam 53, the base-end upper cam 53 is pressed by the cam pressing projection 69 and the base-end portion of the locking member 42 is pushed downward. When the locking member 42 is retracted, the base-end sliding surface 52 is pressed by the oblique surface 39A of the base-end lower cam 39, and the base-end portion of the locking member 42 is pushed upward.

The fulcrum portion 55 is a portion which supports the tip portion of the locking member 42 and serves as the center of rotation. The fulcrum portion 55 is a portion serving as a fulcrum in the action of a lever. The fulcrum portion 55 is formed in a square shape having an almost right angle on the under face of the tip portion of the locking member 42. At the vertex portion of the fulcrum portion 55 having the square shape, the tip sliding surface 55A is formed. The tip sliding surface 55A is a portion which comes into slidable contact with the oblique surface 40A of the tip-side cam 40 to vertically move the tip fitting portion 56 of the locking member 42. The tip sliding surface 55A is formed by obliquely cutting the vertex portion of the fulcrum portion 55. The tip sliding surface 55A is mirror-finished so as to reduce frictional resistance with the oblique surface 40A of the tip-side cam 40. When the locking member 42 is projected in a state where the tip sliding surface 55A is in slidable contact with the oblique surface 40A of the tip-side cam 40, the tip fitting portion 56 of the locking member 42 is pushed upward. When the locking member 42 is retracted, the tip portion of the locking member 42 is pushed downward.

Further, the fulcrum portion 55 is fit in the fitting recess 40B of the tip-side cam 40 and swings around the fitting recess 40B as a center.

The tip fitting portion 56 is a portion which is projected to the outside from the opening 34 in the recess 33 and is directly fit in the second fitting portion 24 of the lid unit receiving portion 21. The tip fitting portion 56 serves as the point of application in the action of a lever. The tip fitting portion 56 is provided with a small distance from the fulcrum portion 55 so as to display sufficient power in a state where it is fit in the second recess 24 in the lid unit receiving portion 21.

The base-end side plates 57 and the tip side plates 58 are members for allowing reciprocating movement while supporting the locking member 42.

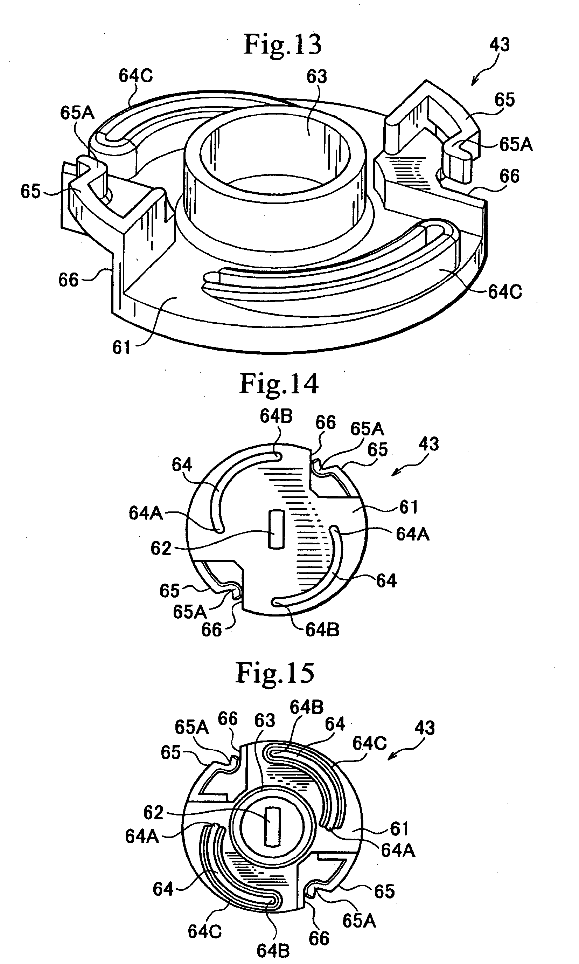

The feeding member 43 is a member which is connected to the locking member 42 to make the locking member 42 project/retract. The feeding member 43 is rotatably attached to the rotation supporting shaft 36 of the recess 33. The feeding member 43 is constructed by, as shown in FIGS. 1, 7, 12, 13, 14, and 15, a top plate 61, a key groove 62, the rotation cylindrical portion 63, the arched elongated hole 64, and an engagement piece 65.

The top plate 61 is formed in an almost disc shape. In two opposite positions in the top plate 61, notches 66 each for providing the engagement piece 65 are formed.

The key groove 62 is a groove in which a latch key of a lid unit attaching/detaching apparatus (not shown) is fit at the time of automatically attaching/detaching the lid unit 15 for the manufacturing line by the apparatus. The key groove 62 is provided in the center of the upper surface of the top plate 61.

The rotation cylindrical portion 63 is a member for rotatably attaching the feeding member 43 to the rotation supporting shaft 36 of the recess 33. The rotation cylindrical portion 63 is provided in the center of the under surface of the top plate 61. In the center of the rotation cylindrical portion 63, the key groove 62 is positioned.

The arched elongated hole 64 is a portion for converting the rotation of the feeding member 43 to the projecting/retracting operation of the locking member 42. The arched elongated hole 64 is formed in each of two opposite positions in the top plate 61. The arched elongated hole 64 is formed by a part of a spiral so that its one end 64A is close to the center of the top plate 61 and the other end 64B is far from the center. When the coupling shaft 51 of the locking member 42 is fit at the one end 64A of the arched elongated hole 64, the locking member 42 is retracted. When the coupling shaft 51 is fit at the other end 64B, the locking member 42 is projected.

On the under surface of the top plate 61 in the arched elongated hole 64, a gently sloped wall surface 64C is provided. The wall surface 64C is set so that its height is the same as that of the under surface of the top plate 61 at one end 64A of the arched elongated hole 64 and gradually increases toward the other end 64B in order to connect the locking member 42 and the feeding member 43 with reliability. That is, in a state where the coupling shaft 51 of the locking member 42 is fit in the other end 64B of the arched elongated hole 64, the base-end portion of the locking member 42 is pushed downward. Even in the state where the base-end portion is pushed down, with the structure, the coupling shaft 51 can be fit in the arched elongated hole 64 with reliability.

The engagement piece 65 is a member for supporting the feeding member 43 in a state where the feeding member 43 swings only by a predetermined angle. The engagement pieces 65 are provided in two opposite positions in the periphery of the top plate 61. The engagement piece 65 is constructed by a plate member extended from the top plate 61 along the periphery. At the tip of the engagement piece 65, the projection 65A to be fit in the receiving portion 37A of the stopper 37 is provided. The engagement piece 65 has elasticity and elastically supports the projection 65A. By fitting of the projection 65A in the receiving portion 37A of the stopper 37, the feeding member 43 is supported at the predetermined swing angle (an angle at which the locking member 42 is projected to fix the lid unit 15 for the manufacturing line to the container body 12).

The cam mechanism 44 is a member which comes into contact with the top face of the second fitting portion 24 in a state where the tip fitting portion 56 of the locking member 42 fed by the feeding member 43 is fit in the second fitting portion 24 in the lid unit receiving portion 21 to thereby press the lid unit 15 for the manufacturing line downward and fix the lid unit 15 to the container body 12 side. With the cam mechanism 44, the tip fitting portion 56 of the locking member 42 fed by the feeding member 43 is pressed down so as to come into contact with the top face of the second fitting portion 24 and the base-end portion is pressed downward, thereby pressing the lid unit 15 for the manufacturing line downward and fixing the lid unit 15 to the container body 12 side by the action of a lever. The cam mechanism 44 is constructed by the base-end lower cam 39, base-end upper cam 53, base-end-side sliding surface 52, cam pressing projection 69, tip-side cam 40, and tip sliding surface 55A. The base-end lower cam 39, base-end upper cam 53, base-end-side sliding surface 52, tip-side cam 40, and tip sliding surface 55A are as described above.

The cam pressing projection 69 is a member which comes into contact with the oblique surface 53A of the base-end upper cam 53 and presses the base-end portion of the locking member 42 downward in association with projection of the locking member 42. The cam pressing projection 69 is provided on the under face of the holding cover 45. Specifically, in a state where the base-end-side sliding surface 52 of the locking member 42 is in slidable contact with the oblique surface 39A of the base-end lower cam 39, the cam pressing projection 69 is positioned so as to be in slidable contact with the oblique surface 53A of the base-end upper cam 53 without a gap.

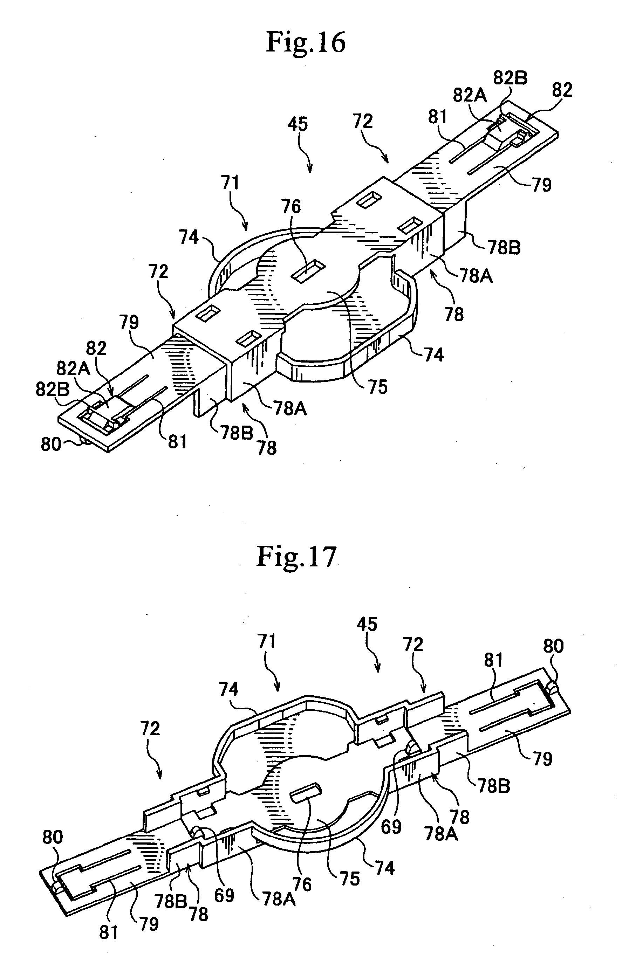

The holding cover 45 is a member for holding the locking member 42 and the feeding member 43. The holding cover 45 is constructed by, as shown in FIGS. 16 and 17, a feeding member holding portion 71 and a locking member holding portion 72.

The feeding member holding portion 71 is a member for supporting the feeding member 43 in a state where rotation of the feeding member 43 is allowed. The feeding member holding portion 71 is constructed by peripheral plates 74 and a top plate 75. The peripheral plates 74 are formed so as to cover the periphery of the feeding member 43. The top plate 75 is formed so as to cover the upper side of the feeding member 43. In the center portion of the top plate 75, a key hole 76 having the same size as that of the key groove 62 in the feeding member 43 is provided. The key hole 76 is aligned with the key groove 62 in the feeding member 43 in a state where the feeding member 43 is covered with the top plate 75. With the configuration, in a state where the locking member 42 is retracted, the key groove 62 and the key hole 76 are aligned with each other.

The locking member holding portion 72 is a member for supporting the locking member 42 in a reciprocating state. The locking member holding portions 72 are provided on both right and left sides of the feeding member holding portion 71. Each of the locking member holding portions 72 is constructed by side plates 78 and a top plate 79.

The side plates 78 are members for supporting the base-end portion of the locking member 42 from the right and left sides. The side plate 78 is constructed by a wide portion 78A and a narrow portion 78B. The wide portion 78A is a portion into which the base-end side plate 57 of the locking member 42 is fit. The narrow portion 78B is a portion in which the portion between the base-end side plate 57 and the tip-side plate 58 in the locking member 42 is fit.

The top plate 79 is a member for supporting the locking member 42 from above. In the base-end portion in the under face of the top plate, the above-described cam pressing projection 69 is provided. At the ends in the under face of the top plate 79, projections 80 for support, which are fit into the upper grooves 54 in the locking member 42, are provided. On the tip side of the top plate 79, slits 81 are opened and a projected portion 82 is provided at the end of the slit 81. The projected portion 82 is constructed by a center projected piece 82A and right and left retaining pieces 82B and is elastically supported by the slits 81. When the center projected piece 82A and the right and left retaining pieces 82B of the projected portion 82 are fit in a cross-shaped notch 86A of the cover presser 46, the holding cover 45 and the cover presser 46 are positioned.

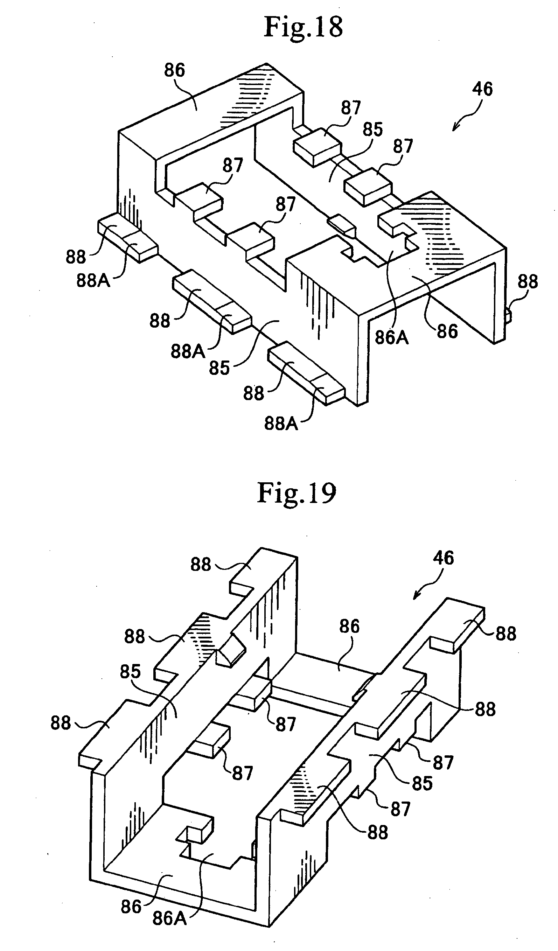

As shown in FIGS. 1, 18, and 19, the cover presser 46 is a member for fixing the holding cover 45 to the recess 33 in the lid unit 15 for the manufacturing line. Specifically, the two cover pressers 46 supports each of the locking member holding portions 72 to fix the holding cover 45 to the recess 33. The cover presser 46 is constructed by side plates 85, a top plate 86, upper supporting plate pieces 87, and the lower supporting plate pieces 88.

The side plates 85 cover the right and left sides of the locking member 42 while allowing reciprocating motion of the locking member 42. The top plate 86 integrally supports the side plates 85 and covers the top of the locking member 42 while allowing reciprocating motion of the locking member 42. The upper supporting plate pieces 87 are members for supporting the top plate 79 of the locking member holding portion 72 of the holding cover 45 from below. The top plate 79 of the locking member holding portion 72 is supported from top and bottom by the top plate 86 and upper supporting plate pieces 87 of the cover presser 46. The lower supporting plate piece 88 is a portion for fixing the cover presser 46 to the recess 33. Three lower supporting plate pieces 88 are provided at the lower end of each of the side plates 85. The lower supporting plate pieces 88 fit with the locking pawls 38 provided for the recess 33, thereby fixing the cover presser 46 to the recess 33. Each of the lower supporting plate pieces 88 has a taper 88A so as to easily fit with the locking pawl 38.

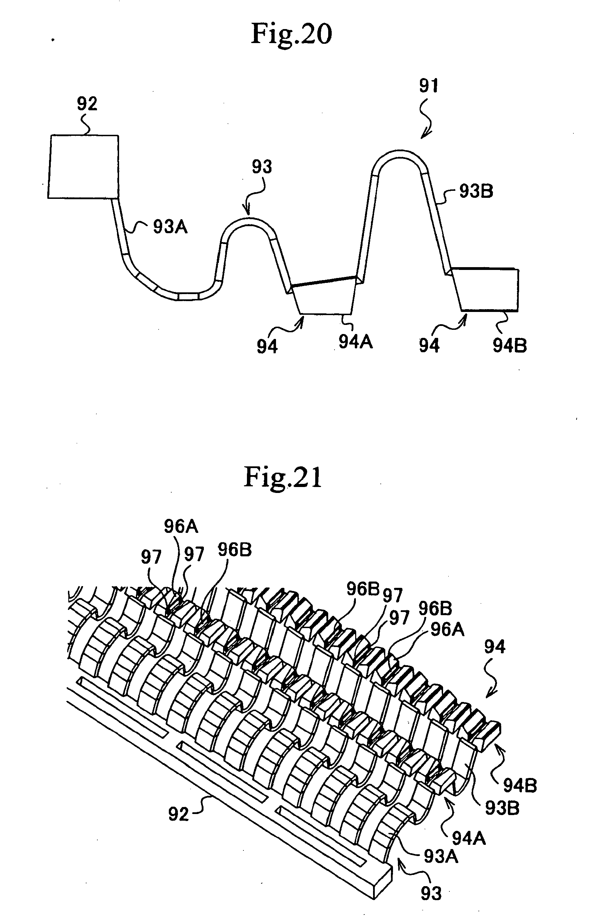

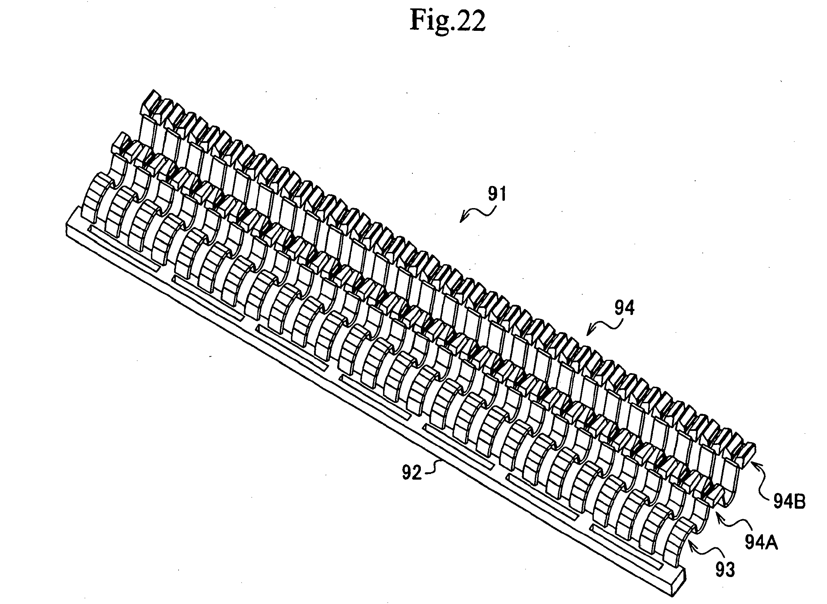

On the under face of each of the lid unit 14 for transport and the lid unit 15 for the manufacturing line, as shown in FIGS. 20 to 22, a wafer presser 91 as a thin plate presser is provided. The wafer presser 91 is a member for supporting a plurality of semiconductor wafers housed in the container body 12 from above. The wafer presser 91 is constructed by a base-end supporting portion 92, an elastic supporting plate 93 and contact pieces 94.

The base-end supporting portion 92 is a member for supporting the elastic supporting plate 93 and the contact pieces 94. The base-end supporting portion 92 is formed in a square bar shape along the overall length of the wafer presser 91 and is fixed on the under face of the lid unit.

The elastic supporting plate 93 is a member for elastically supporting the contact piece 94. The elastic supporting plates 93 are arranged, as many as the number corresponding to the number of semiconductor wafers housed in the container body 12. The elastic supporting plates 93 are fixed to the base-end supporting portion 92 in a state where they are arranged in a horizontal line. The elastic supporting plate 93 is constructed by a first supporting plate piece 93A bent in an S shape in side view and a second supporting plate piece 93B bent in an U shape. The base-end portion of the first supporting plate piece 93A is fixed to the base-end supporting portion 92, and a first contact piece 94A is fixed at the tip of the first supporting plate piece 93A. The base-end portion of the second supporting plate piece 93B is integrally connected to the first supporting plate piece 93A via a first contact piece 94A, and a second contact piece 94B is fixed to the tip of the second supporting plate piece 93B.

The contact piece 94 is a member for directly supporting a semiconductor wafer. The contact piece 94 is constructed by the first contact piece 94A and the second contact piece 9 4B and each semiconductor wafer is supported in two positions. The contact piece 94 is constructed by two blocks 96 and supporting pawls 97 alternately arranged.

Each of the blocks 96 has an inclined surface 96A and a contact surface 96B. The inclined surface 96A is formed so that the two blocks 96 are open to the outside in a state where they are attached so as to face each other. Consequently, the peripheral portion of a semiconductor wafer is easily inserted between the two blocks 96. The contact surfaces 96B are formed so as to construct a groove having a predetermined width (width slightly wider than the thickness of the semiconductor wafer) in a state where the two neighboring blocks 96 are attached so as to face each other.

The supporting pawls 97 are members which come into direct contact with the peripheral portion of a semiconductor wafer to support the semiconductor wafer. The supporting pawl 97 is provided for the contact surface 96B of each block. The supporting pawl 97 takes the form of a vertically-long projection. The supporting pawls 97 are provided on the facing contact surfaces 96B in a staggered configuration. Specifically, two supporting pawls 97 are provided at both ends of the contact surface 96B as one of the contact surfaces 96B, and one supporting pawl 97 is provided in the center of the other contact surface 96B, thereby disposing the facing supporting pawls 97 in a staggered configuration. Each of the supporting pawls 97 is formed by an elastic material, and elastically supports the peripheral portion of a semiconductor wafer. Since the width between the two contact surfaces 96B is slightly wider than the thickness of the semiconductor wafer, the interval between the tips of the supporting pawls 97 disposed on the contact surfaces 96B is narrower than the thickness of the semiconductor wafer. Consequently, the semiconductor wafer is inserted between the supporting pawls 97 while slightly pushing the supporting pawls 97 made of the elastic member and disposed alternately. Accordingly, the peripheral portion of a semiconductor wafer is supported by the supporting pawls 97 disposed alternately with reliability.

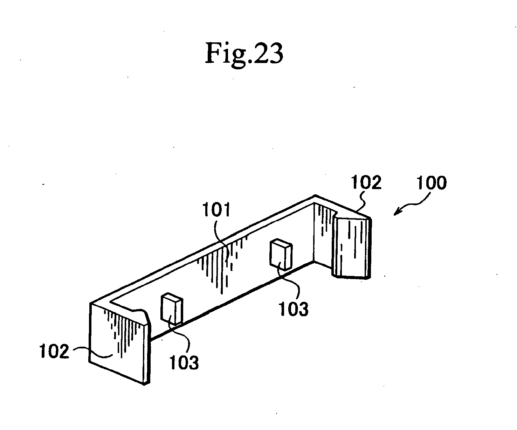

A lid unit holder 100 is provided on the outside of the lid unit 15 for the manufacturing line, as shown in FIG. 23. The lid unit holder 100 is a member for preventing the lid unit 15 for the manufacturing line from being come off from the container body 12. The lid unit holder 100 is constructed by a supporting plate 101, hooks 102, and fitting projections 103.

The supporting plate 101 is a member for supporting the hooks 102 and the fitting projections 103. The hooks 102 are provided at both ends of the supporting plate 101. The hooks 102 are caught by the flange of the container body 12.

The fitting projections 103 are provided on one side surface of the supporting plate 101. The fitting projection 103 is formed in the same shape as the key groove 62 and is fit into the key groove 62 via the key hole 76. Two fitting projections 103 are provided in the positions aligned with the two key grooves 62. Consequently, in a state where the hooks 102 are caught by the flange of the container body 12, the fitting projections 103 are fit in the key grooves 62 to fix the feeding member 43. This is to prevent the lid unit 15 for the manufacturing line fixed to the container body 12 from being loosened when the feeding member 43 swings due to vibration, shock, and the like during transportation of the thin plate supporting container.

The thin plate supporting container 11 constructed as described above is used as follows.

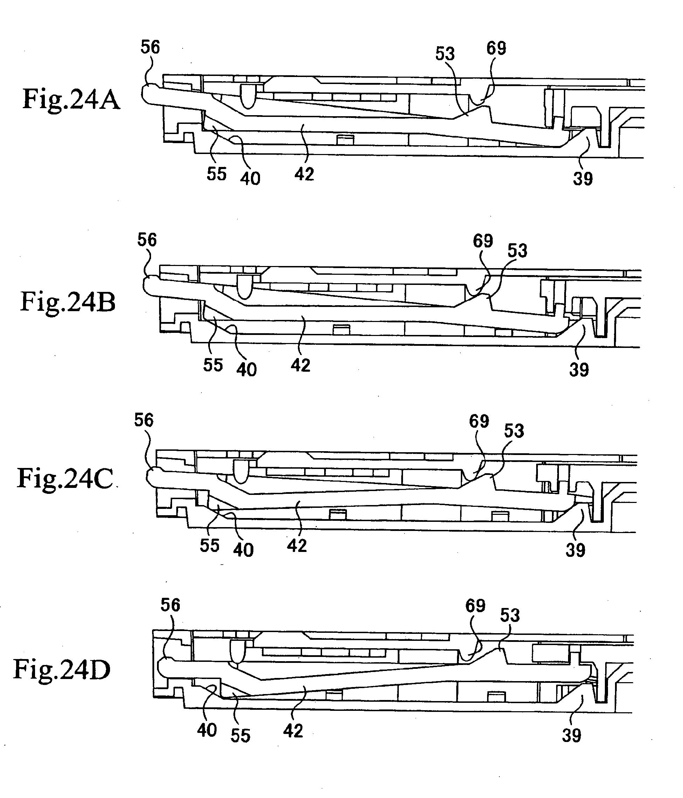

In the case of detaching the lid unit 15 for the manufacturing line from the container body 12, the latch key is inserted in the key groove 62 and turned. By the operation, from the state of FIG. 24A, the feeding member 43 is turned and the locking member 42 is gradually retracted. The tip sliding surface 55A of the fulcrum portion 55 of the locking member 42 slides along the oblique surface 40A of the tip-side cam 40 and, as shown in FIGS. 24B, 24C, and 24D, the tip fitting portion 56 is pushed downward. Simultaneously, the base-end sliding surface 52 of the locking member 42 slides along the oblique surface-39a of the base-end lower cam 39, and the base-end portion of the locking member 42 is pushed up. The tip fitting portion 56 is thereby completely housed in the body 30. After that, the lid unit 15 for the manufacturing line is detached from the container body 12.

In the case of attaching the lid unit 15 for the manufacturing line to the container body 12, the lid unit 15 for the manufacturing line is attached to the lid unit receiving portion 21 and the latch key is fit in the key groove 62 and turned. By the operation, in contrast to the above case, the locking member 42 is projected from the body 30. At this time, the fulcrum portion 55 of the locking member 42 slides along the oblique surface 40A of the tip-side cam 40 and the tip fitting portion 56 is pushed upward. Further, the cam pressing projection 69 comes into contact with the oblique surface 53A of the base-end upper cam 53 and the base-end portion of the locking member 42 is pressed down. By the operation, the base-end sliding surface 52 of the locking member 42 is pushed downward along the oblique surface 39A of the base-end lower cam 39.

In the fulcrum portion 55 of the locking member 42, the tip sliding surface 55A fits in the fitting recess 40B, and the locking member 42 swings around the fitting recess 40B as a center.

In the base-end portion of the locking member 42, the base-end-side sliding surface 52 slides along the oblique surface 39A of the base-end lower cam 39 and the cam pressing projection 69 comes into contact with the oblique surface 53A of the base-end upper cam 53 to press the base-end portion of the locking member 42 downward.

The locking member 42 functions as a lever using the fulcrum portion 55 fit in the fitting recess 40B as a fulcrum and, in a state where the tip fitting portion 56 is fit in the second fitting portion 24 of the lid unit receiving portion 21, strongly presses the lid unit 15 for the manufacturing line against the container body 12 so as to be fixed.

In a state where the lid unit 15 for the manufacturing line is attached to the container body 12, the lid unit holder 100 is attached. Specifically, the hooks 102 are caught by the flange of the container body 12, so that the fitting projections 103 are fit in the key groove 62 to fix the feeding member 43.

In the container body 12, the peripheral portion of a semiconductor wafer is fit in the contact piece 94. In the contact piece 94, the peripheral portion of the semiconductor wafer is fit between the supporting pawls 97 disposed in a staggered configuration and is firmly supported by the supporting pawls 97.

In the case where a strong shock is applied from the outside of the thin plate supporting container 11, since the locking member 42 strongly presses the lid unit 15 for the manufacturing line against the container body 12 by the action of a lever, the lid unit 15 for the manufacturing line is not taken off from the container body 12. Further, since the feeding member 43 is fixed by the lid unit holder 100, the locking member 42 does not come off from the second fitting portion 24 due to turn of the feeding member 43.

On the other hand, the semiconductor wafer in the thin plate supporting container 11 is fit in the contact piece 94 of the wafer presser 91 and is supported from both sides by the supporting pawls 97 disposed in a staggered configuration, so that the semiconductor wafer does not come off from the contact piece 94. Further, since the contact piece 94 is supported by the elastic supporting plate 93, the first supporting plate piece 93A and the second supporting plate piece 93B support the semiconductor wafer by their elasticity or by being in contact with the under face of the lid unit 15 for the manufacturing line, and the semiconductor wafer is prevented from being damaged.

In the case of cleaning, by sliding the cover presser 46 so as to be detached from the locking pawls 38, the simple attaching/detaching mechanism 32 can be disassembled into the locking member 42, feeding member 43, cam mechanism 44, holding cover 45, and cover presser 46 which can be individually cleaned and dried.

The thin plate supporting container 11 produces the following effects.
(1) Since the locking member 42 is projected by using the action of a lever, the lid unit 15 for the manufacturing line can be securely fixed to the container body 12 with a strong power.
(2) Since the simple attaching/detaching mechanism can be easily disassembled into component parts, in the case of cleaning the mechanism, the mechanism can be detached and disassembled into the component parts, and the component parts can be individually cleaned and promptly dried.
(3) Since the supporting pawls 97 are disposed in a staggered manner, the supporting pawls 97 come into contact with the periphery of a semiconductor wafer and a semiconductor wafer can be supported with reliability.

### Embodiment

An embodiment of the invention will now be described. The embodiment relates to an improvement in the wafer presser.

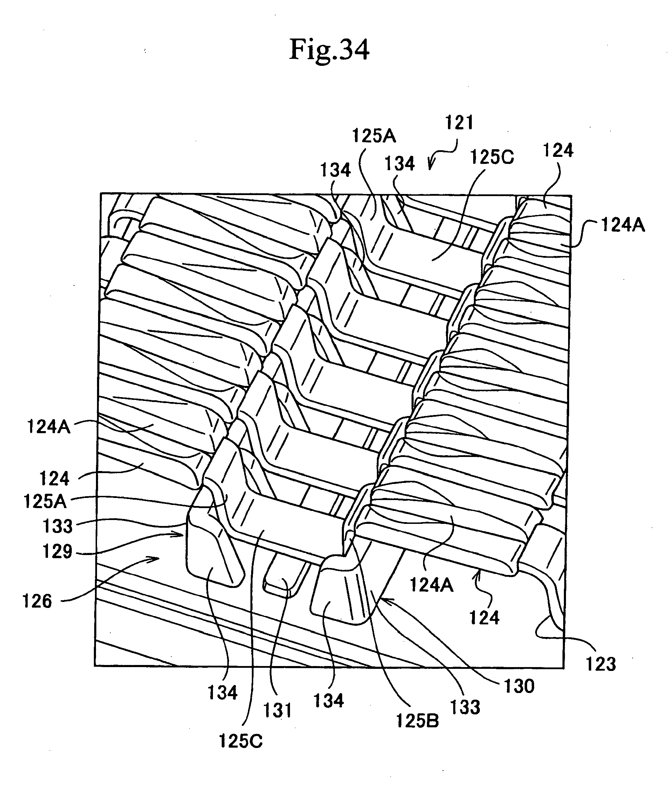

The thin plate supporting container may be shaken due to various factors during transportation. When the shake is transmitted to a semiconductor wafer, in some cases, the semiconductor wafer turns due to the shake and this is undesirable. Consequently, when the thin plate supporting container is used in a mode where it is subjected to shake, a wafer presser (thin plate presser) is used. A wafer presser 121 of the embodiment will now be described with reference to FIGS. 34 to 43. Since the structure is similar to the thin plate supporting container 11 of the above example except for the wafer presser 121, the same reference numerals are designated to the similar members and the description of the similar members will not be repeated.

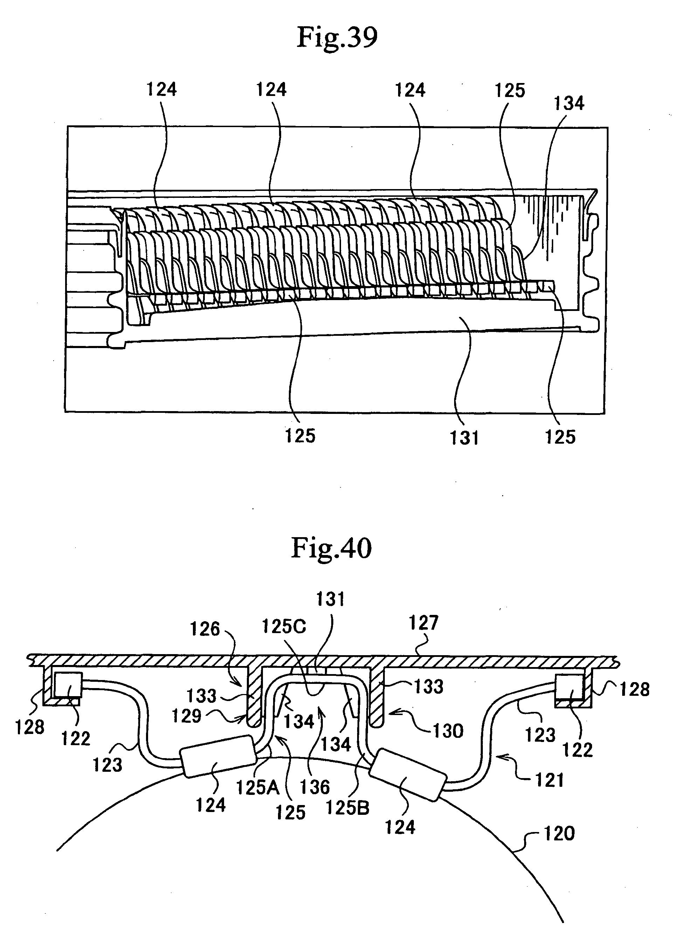

The wafer presser 121 is constructed by, as shown in FIG. 40, base-end supporting portions 122, elastic supporting plates 123, contact pieces 124, a connecting and supporting plate 125, and supporting ribs 126.

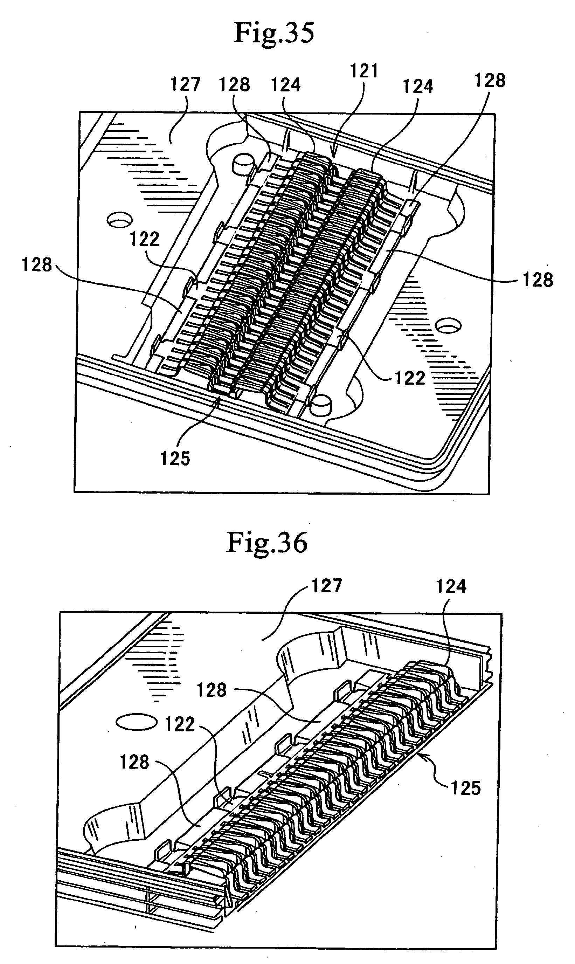

The base-end supporting portions 122 are members provided at both ends of the wafer presser 121, for directly supporting the two elastic supporting plates 123. The base-end supporting portion 122 is formed in a rectangular rod shape so as to extend along the overall length in the longitudinal direction (vertical direction of FIG. 35) of the wafer presser 121. On the under face of a lid unit 127, two hook-shaped supporting portions 128 are provided. The base-end supporting portion 122 is fit in the hook-shaped supporting portion 128 and fixed to the rear face side of the lid unit.

The elastic supporting plate 123 is a member for elastically supporting the outer end of the contact piece 124. The pairs of elastic supporting plates 123 of the number corresponding to the number of semiconductor wafers 120 housed in the container body 12 are arranged. The elastic supporting plates 123 are fixed to the base-end supporting portions 122 in a state where they are arranged in a line. The elastic supporting plate 123 is formed by being bent in an S shape in side view. The base-end portions of the two elastic supporting plates 123 are fixed to two base-end supporting portions 122. The contact piece 124 is attached to the tip of each of the elastic supporting plates 123. The elastic supporting plates 123 elastically support the contact pieces 124.

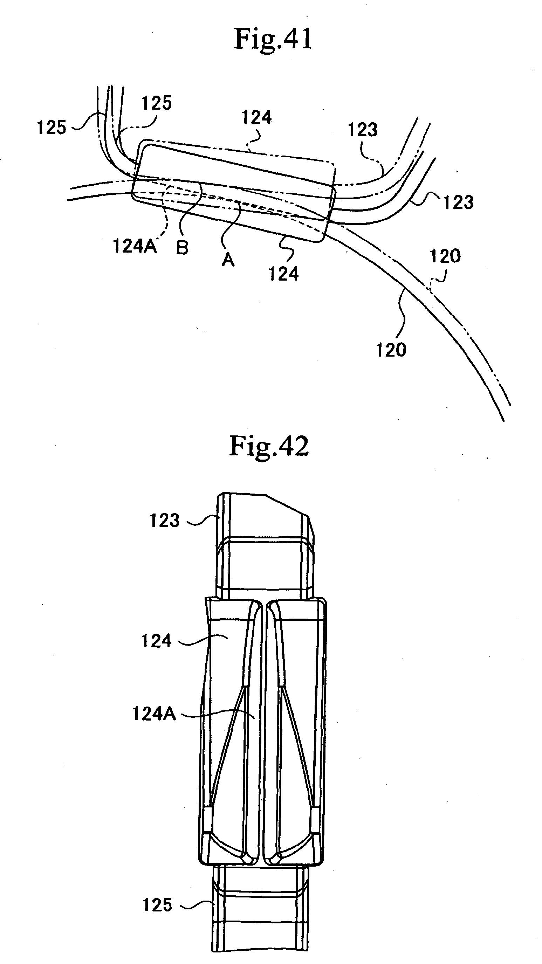

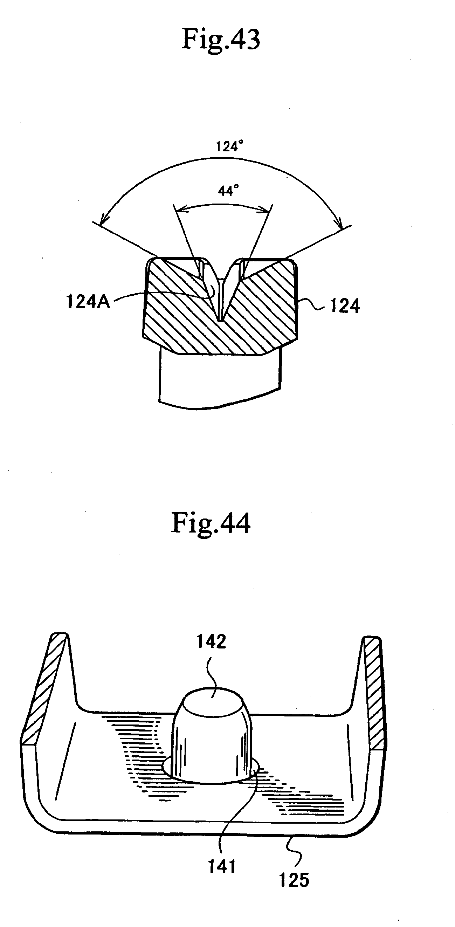

The contact piece 124 is a member which comes into direct contact with the periphery of each semiconductor wafer 120 to directly support the semiconductor wafer 120. As shown in FIGS. 42 and 43, on one side face of the contact piece 124, a V-shaped fitting groove 124A in which the semiconductor wafer 120 fits is provided. The fitting groove 124A is a V-shaped groove having two stages. The groove in the first stage has a gentle inclination of an angle of 124°. The groove in the second stage has an inclination of an angle of 44°. With the structure, when the periphery of the semiconductor wafer 120 comes into contact with the groove in the first stage, the periphery of the semiconductor wafer 120 is guided along the gentle slope and is dropped into the groove in the second stage. In the groove in the second stage, the semiconductor wafer 120 is supported. The bottom of the groove in the second stage is formed in a flat surface having a width which is almost the same as the thickness of the semiconductor wafer 120. The inclination angle of the groove in the second stage and the width of the bottom are set according to the dimensions of the periphery of the semiconductor wafer 120. Since the periphery of the semiconductor wafer 120 is cut at an edge angle of 44°, the inclination angle of the groove is set to 44°. Further, the width of the bottom of the groove is also set in accordance with the width of the periphery of the semiconductor wafer 120. Consequently, when the periphery of the semiconductor wafer 120 is fit in the groove in the second stage, the semiconductor wafer 120 can be supported with reliability while being in contact with a large area and can be prevented from being turned due to shake. Although the groove in the second stage is set to have the inclination of 44° in accordance with the edge angle of the semiconductor wafer 120, the angle may be smaller a little in relation to the material of the contact piece 124. Specifically, the angle of the groove in the second stage is properly set within the range from about 40° to 44° in accordance with variation in elasticity. If the angle of the groove in the second stage is too small, the periphery of the semiconductor wafer 120 may be caught. In such a case, when the lid unit 127 is lifted, the semiconductor wafer 120 may be lifted together. Consequently, the angle is set so as not to catch the semiconductor wafer 120. In the case where the edge angle of the semiconductor wafer 120 varies, in the case of a thin plate other than the semiconductor wafer 120, and the like, the angle is properly set within the range of about 20° to 60° .

As shown in FIGS. 40 and 41, the bottom of the fitting groove 124A is set at an angle according to the shape of the periphery of the semiconductor wafer 120, that is, it is set so as to extend in the tangent direction of the periphery of the semiconductor wafer 120. As will be described later, elasticity increases in proportion to the deflection amount of the wafer presser 121, so that the force of pressing the semiconductor wafer 120 is equalized by the contact pieces 124. That is, as a change amount of one of the two contact pieces 124 increases, the elasticity increases according to the change amount, the contact piece 124 slightly pushes the semiconductor wafer 120 to the other contact piece 124 side, and the elastic forces of the two contact pieces 124 are settled at the same strength. As a result, the elastic forces of the right and left contact pieces are automatically adjusted so as to become the same. Further, it is set so that, in a state where the lid unit 127 is attached to the container body 12, the semiconductor wafer 120 comes into contact with the bottom in an almost center portion (contact A in FIG. 41) of the fitting groove 124A.

The connecting and supporting plate 125 is a member for connecting the two contact pieces 124 and supporting them. Both ends of the connecting and supporting plate 125 are connected to the contact pieces 124 and elastically support the contact pieces 124. The connecting and supporting plate 125 is formed by being bent in an almost U shape in side view. Specifically, the connecting and supporting plate 125 is constructed by vertical plates 125A and 125B on both sides and a horizontal plate 125C. The vertical plates 125A and 125B are disposed in a direction perpendicular to the rear face of the lid unit 127 and support the contact pieces 124 almost without being deflected.

The horizontal plate 125C is elastically deflected. The function of elastically supporting the contact pieces 124 by the connecting and supporting plate 125 is mainly carried out by the horizontal plate 125C. The horizontal plate 125C is disposed so as to be along the rear face of the lid unit 127 in a state where the vertical plates 125A and 125B are connected to both ends of the horizontal plate 125C. The center portion of the horizontal plate 125C is supported by a supporting projection bar 131 which will be described later. Both ends of the horizontal plate 125C are deflected around the supporting projection bar 131 as a center.

The elastic force generated by deformation of the horizontal plate 125 (elastic force for supporting the contact piece 124, of the connecting and supporting plate 125) is set to be stronger than the elastic force of supporting the contact piece 124, of the elastic supporting plate 123. Therefore, the inner ends of the two contact pieces 124 are supported by the stronger elastic force, and the outer ends are supported by the weaker elastic force. The bottom of the fitting groove 124A of each of the two contact pieces 124 is disposed in the tangent direction of the periphery of the semiconductor wafer 120 as described above. With the structure, it is set so that the power of supporting the semiconductor wafer 120, of the wafer presser 121 increases in proportional to the movement amount (amount of shake) of the semiconductor wafer 120. That is, in a normal state, as shown by a solid line in FIG. 41, the semiconductor wafer 120 is supported by being in contact with the bottom of the fitting groove 124A in an almost center portion (contact point A in FIG. 41) of the bottom. When the semiconductor wafer 120 is shaken, the inner end of the contact piece 124 supported by the stronger elastic force of the connecting and supporting plate 125 does not change so much but the external end supported by the weaker elastic force of the elastic supporting plate 123 largely changes, so that, as shown by an imaginary line in FIG. 41, the semiconductor wafer 120 is moved toward the inner end side (contact point B side in FIG. 41) on the bottom of the fitting groove 124A and supported. Therefore, when the amount of shake in the semiconductor wafer 120 is small (the deflection amount of the wafer presser 121 is small), the outer end side (contact point A side in FIG. 41) of the semiconductor wafer 120 comes into contact with the bottom of the fitting groove 124A and is supported with the weaker elastic force. When the amount of shake in the semiconductor wafer 120 increases (the deflection amount of the wafer presser 121 increases), the contact point of the semiconductor wafer 120 moves toward the inner end (contact point B side in FIG. 41) of the fitting groove 124A and the semiconductor wafer 120 is supported with the stronger elastic force. Further, as the amount of movement to the inner end of the contact point of the semiconductor wafer 120 increases, the power applied to the connecting and supporting plate 125 increases more than to the elastic supporting plate 123, and the elastic force increases, so that shake of the semiconductor wafer 120 is efficiently suppressed.

The supporting rib 126 is a supporting member for supporting the connecting and supporting plate 125 to prevent the connecting and supporting plate 125 from being deviated in the direction along the rear face of the lid unit. The supporting rib 126 is provided in the center portion of the rear face of the lid unit 127 as shown in FIGS. 34 to 40. The supporting rib 126 is provided so as to cover all of a number of connecting and supporting plates 125 of the wafer presser 121 disposed. Specifically, the supporting rib 126 is set to have a length in which all of the connecting and supporting plates 125 arranged of the number corresponding to the number of the semiconductor wafers 120 to be housed can be fit. The supporting rib 126 is constructed by two supporting walls 129 and 130.

The supporting walls 129 and 130 are provided so as to face each other and in parallel with each other. Each of the supporting walls 129 and 130 is constructed by a supporting plate piece 133 and a partition plate piece 134.

The supporting plate piece 133 is a member for supporting the vertical plates 125A and 125B of the connecting and supporting plate 125 so as not to be deviated in the circumferential direction of the semiconductor wafer 120 (the lateral direction in FIG. 40). The supporting plate piece 133 directly supports the vertical plates 125A and 125B of the connecting and supporting plate 125, thereby indirectly supporting the contact pieces 124 so as not to be deviated in the circumferential direction of the semiconductor wafer 120.

The partition plate pieces 134 are plate pieces for partitioning a number of connecting and supporting plates 125 disposed. The partition plate pieces 134 are positioned on the outermost sides and between the neighboring connecting and supporting plates 125. Accordingly, the partition plate pieces 134 support each of the connecting and supporting plates 125 from both sides in the width direction. The partition plate pieces 134 directly support the connecting and supporting plates 125, thereby indirectly supporting the contact pieces 124 so as not to be deviated in the direction orthogonal to the circumferential direction of the semiconductor wafer 120.

By sandwiching the connecting and supporting plate 125 with the supporting plate piece 133 and the partition plate piece 134 from the periphery (in the direction orthogonal to the circumferential direction of the semiconductor wafer 120 housed in the container body 12), a deviation in the direction along the rear surface of the lid unit of the connecting and supporting plate 125 is prevented and fluctuations in the direction perpendicular to the rear surface of the lid unit are allowed.

The supporting plate piece 133 and the partition plate piece 134 and the connecting and supporting plate 125 are set so as to have a small gap therebetween, thereby preventing coming into contact with each other when small shake occurs. That is, when the semiconductor wafer 120 is shaken slightly, the connecting and supporting plate 125 is deflected without coming into contact with the supporting plate piece 133 and the partition plate piece 134, thereby absorbing shake. When the shake becomes harder, the connecting and supporting plate 125 is also shaken hard via the contact pieces 124. Consequently, the connecting and supporting plate 125 is supported by being in contact with the supporting plate piece 133 and the partition plate piece 134.

Between the two supporting walls 129 and 130 of the supporting ribs 126, as shown in FIG. 34 and FIGS. 37 to 39, the supporting projection bar 131 is provided. The supporting projection bar 131 is a member which is in direct contact with the connecting and supporting plates 125 to support the connecting and supporting plates 125. Specifically, the center portion of the horizontal plate 125C of each of the connecting and supporting plates 125 is supported by the supporting projection bar 131 by being in contact, and both ends of the horizontal plate 125C can be freely deflected. The supporting projection bar 131 is provided in the center portion between the two supporting walls 129 and 130 in parallel with the supporting walls 129 and 130, and its length is almost the same as the supporting walls 129 and 130. The two supporting walls 129 and 130 are provided in parallel so as to face each other.

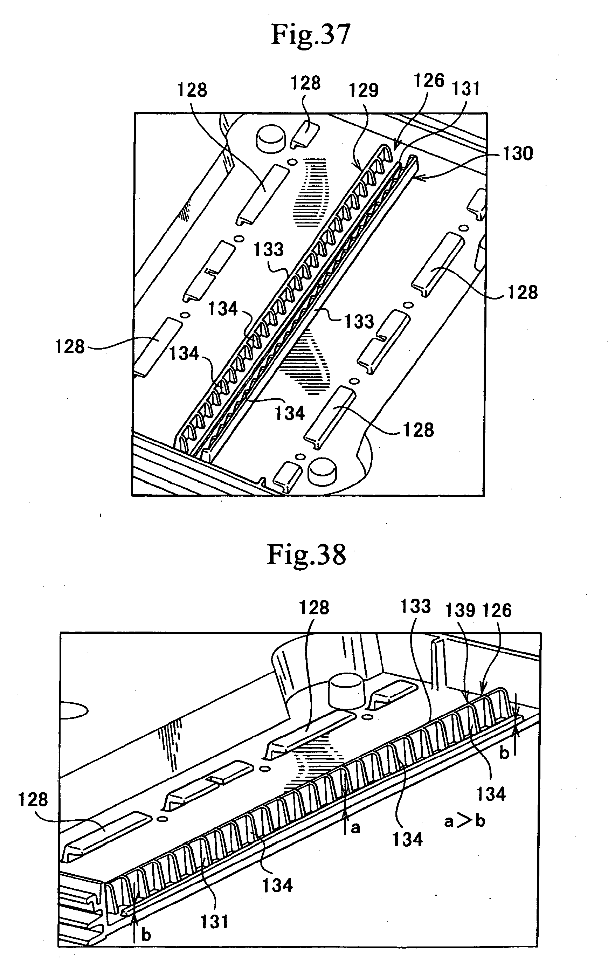

The supporting projection bar 131 is as shown in FIGS. 38 and 39. That is, the supporting projection bar 131 is formed in such a manner that both sides are thin ("b" side in FIG. 38) and the center side ("a" side in FIG. 38) is thick so as to make the contact piece 124 positioned in the center projected to the semiconductor wafer 120 side more than the contact pieces 124 positioned on both sides. In the embodiment, the supporting projection bar 131 is formed so as to be arched as a whole. By the structure, it is set so that, as shown in FIG. 39, the interval between the supporting projection bar 131 and the connecting and supporting plates 125 is wide on both sides and narrow in the center in a state where the wafer presser 121 is attached to the lid unit 127. Specific dimensions of the supporting projection bar 131 are properly set in accordance with the deflection amount of the lid unit 127.

The supporting projection bar 131 is formed as described above for the following reasons. When the lid unit 127 is attached in a state where a plurality of semiconductor wafers 120 are housed in the container body 12, predetermined repulsion acts on the lid unit 127. The wafer presser 121 attached to the rear face of the lid unit supports each of the semiconductor wafers 120 with certain force. Consequently, the larger the force of supporting the semiconductor wafer 120 becomes in association with increase in the diameter of the semiconductor wafer 120 or the larger the number of the semiconductor wafers 120 becomes, the larger the repulsion to the wafer presser 121 becomes. By the repulsion, the lid unit 127 to which the wafer presser 121 is attached is slightly deflected to the outside. When the lid unit 127 is deflected to the outside, the force of supporting the semiconductor wafers 120 by the wafer presser 121 becomes weaker in the center portion. To solve nonuniform force of supporting the semiconductor wafers 120, the supporting projection bar 131 is provided. By the supporting projection bar 131 of which center portion is thicker, deflection of the lid unit 127 is absorbed. The wafer presser 121 supports the semiconductor wafers 120 with uniform force.

The thin plate supporting container having structure as described above acts as follows.

When the lid unit 127 is attached in a state where a plurality of semiconductor wafers 120 are housed in the container body 12, the wafer presser 121 fits with the semiconductor wafers 120. Specifically, the fitting groove 124A in each of the contact pieces 124 fits with the periphery of the semiconductor wafer 120, and the periphery of the semiconductor wafer 120 is guided to the bottom of the fitting groove 124A. In a state where the periphery of the semiconductor wafer 120 is fit in the groove in the second stage, the periphery of the semiconductor wafer 120 is caught in the groove in the second stage, and a wide area of the semiconductor wafer 120 is in contact with the groove and supported with reliability. Each of the contact pieces 124 is supported by the elastic supporting plate 123 and the connecting and supporting plate 125.

The elastic supporting plate 123 elastically supports the outer end of each of the contact pieces 124 by its tip portion in a state where its base-end portion is supported by the base-end supporting portion 122 fixed to the rear face of the lid unit 127. The connecting and supporting plate 125 elastically supports the inner end of the contact piece 124 by its both ends in a state where the center portion is supported by the supporting ribs 126.

Further, the arched supporting projection bar 131 supports the contact piece 124 in a state where the supporting projection bar 131 absorbs deflection of the lid unit 127. Accordingly, the contact pieces 124 support the semiconductor wafers 120 with uniform force.

The inner end of each of the contact pieces 124 is elastically supported with relatively strong force and the outer end is elastically supported with relatively weak force. At this time, the contact piece 124 is in contact with the semiconductor wafer 120 in a state where the bottom portion of the fitting groove 124A is along the tangential direction of the periphery of the semiconductor wafer 120. The elastic forces of the two contact pieces 124 are automatically adjusted so as to be the same to equalize the force of pressing the semiconductor wafer 120 as a whole. In such a manner, the semiconductor wafer 120 is stably supported.

When shake is applied to the thin plate supporting container during transportation or the like of the thin plate supporting container, the semiconductor wafer 120 is also shaken. Further, according to the shake of the semiconductor wafer 120, the contact pieces 124 is also shaken.

When the shake is small, the amplitude of each of the contact pieces 124 is small, so that the contact point between the semiconductor wafer 120 and the contact piece 124 is on the outer side (for example, around the contact point A in FIG. 41). The elastic supporting plate 123 is mainly deflected, and the semiconductor wafer 120 is supported with weak elastic force.

When the shake is large, the amplitude of the contact piece 124 is large, so that the contact point between the semiconductor wafer 120 and the contact piece 124 is shifted to the inner side (for example, around the contact point B in FIG. 41). According to the shift amount, the force applied to the connecting and supporting plate 125 becomes larger than that to the elastic supporting plate 123, and the elastic force increases. Consequently, when the semiconductor wafer 120 is largely shaken, the contact piece 124 pushes back the semiconductor wafer 120 with strong elastic force, thereby suppressing the shake of the semiconductor wafer 120. In such a manner, according to the strength of shake, the force of supporting the semiconductor wafer 120 is automatically changed and the semiconductor wafer 120 is supported with reliability.

As a result, all of the semiconductor wafers 120 are supported with uniform force, the shake of the semiconductor wafer 120 caused by shake from the outside can be minimized, and the semiconductor wafer 120 can be prevented from rotating.

### Modifications

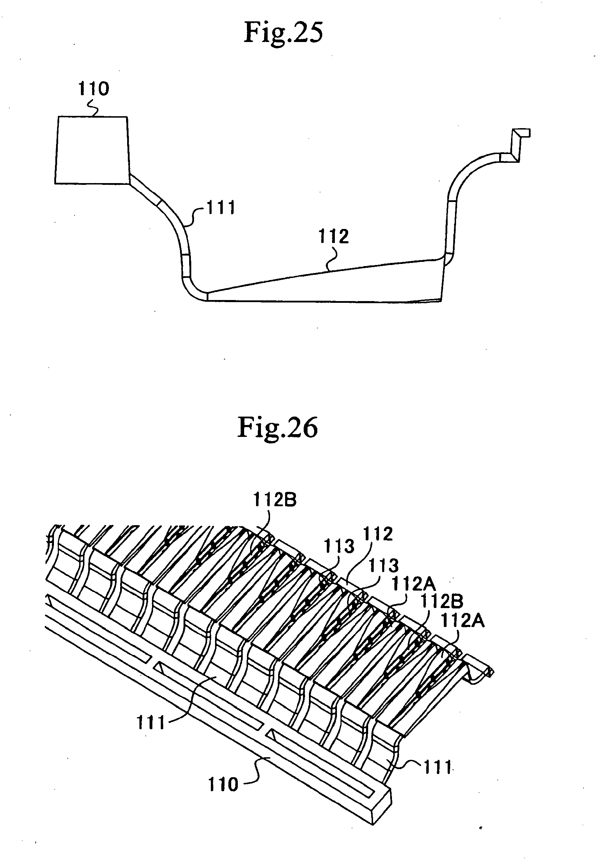

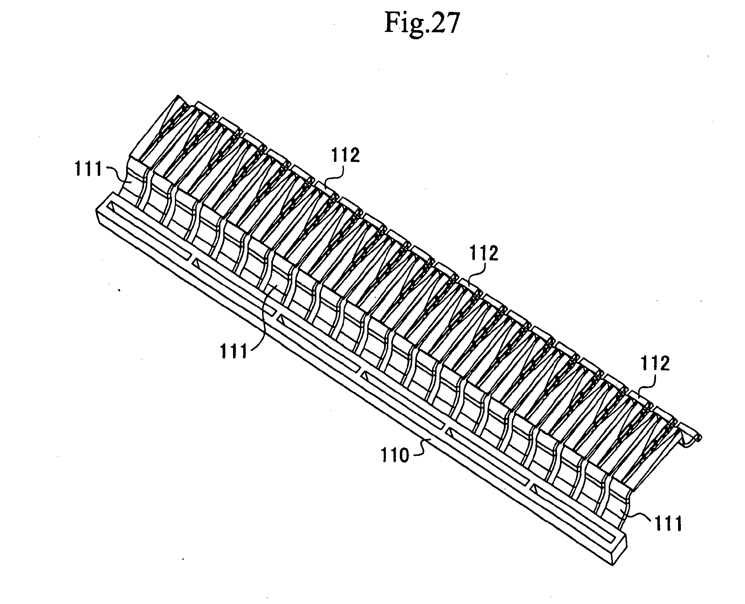

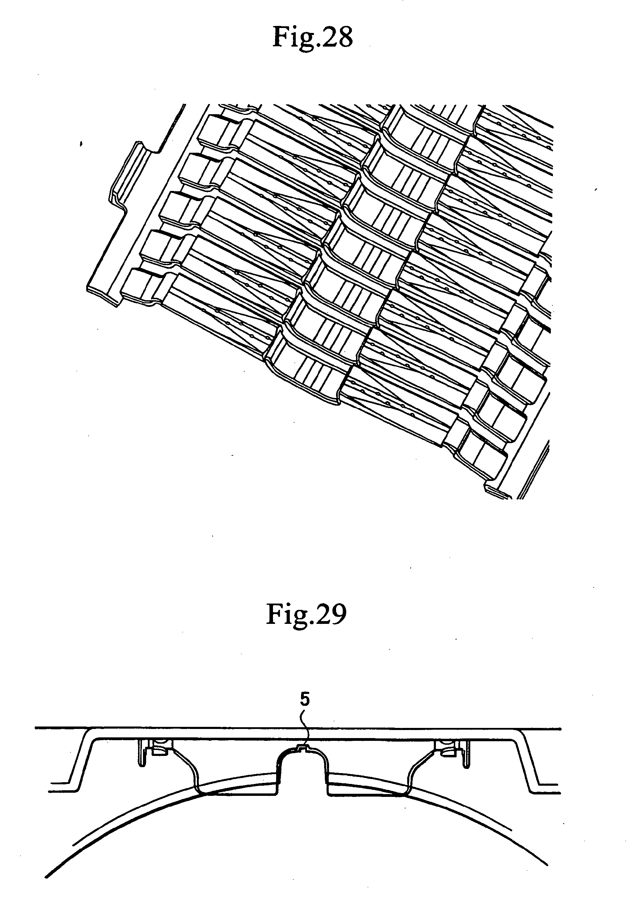

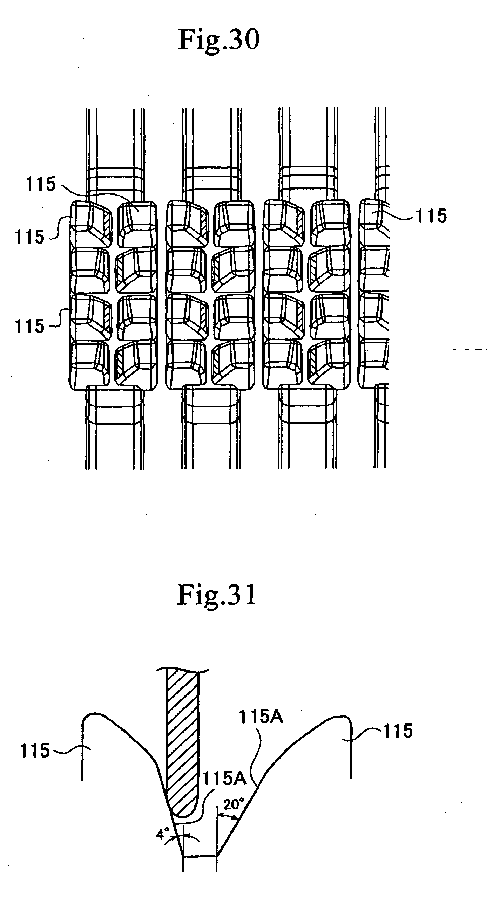

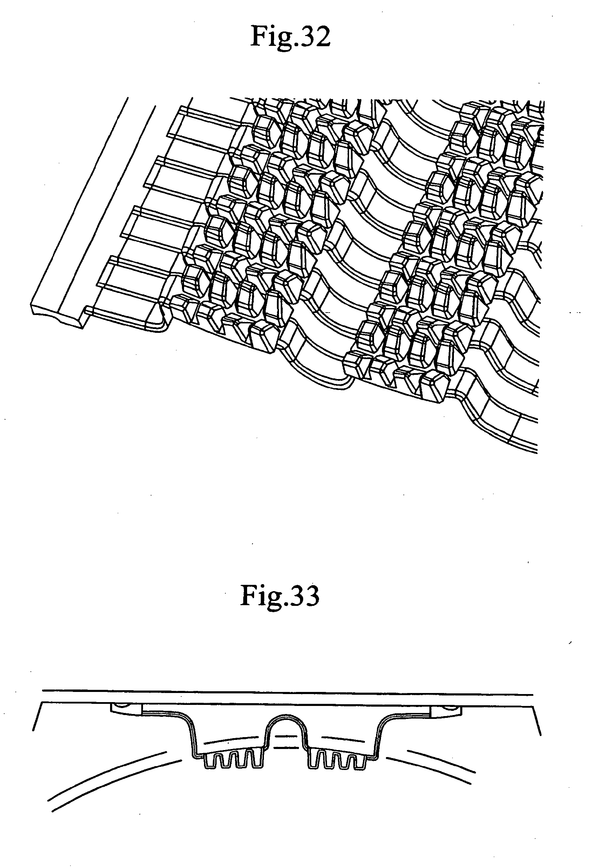

(1) In the example, the wafer presser 91 is constructed by the base-end supporting portion 92, elastic supporting plate 93, and contact piece 94. In a modification, as shown in FIGS. 25, 26, and 27, the wafer presser is constructed by a base-end supporting portion 110, an elastic supporting plate 111, and a contact piece 112. The elastic supporting plate 111 supports one end of the contact piece 112 in a state where the base-end portion of the elastic supporting plate 111 is fixed to the base-end supporting portion 110. Further, the elastic supporting plate 111 is extended from the other end of the contact piece 112 to the under face of the lid unit 15 for the manufacturing line. An inclined surface 112A and a contact surface 112B of the contact piece 112 have functions similar to those of the inclined surface 96A and the contact surface 96B, respectively, of the above example. Three supporting pawls 113 on the inclined face 112A and three supporting pawls 113 on the contact face 112B are disposed so as to face each other alternately. The number of the supporting pawls 113 may be changed if necessary.
   The structure can also produce actions and effects similar to those of the above example.
(2) Although the wafer presser 91 has a one-side supporting structure in the example, as shown in FIGS. 28 and 29, it can also have a both-side supporting structure. The elastic supporting plate is attached between and on both sides of the contact pieces so as to support the contact pieces in a state where the elastic supporting plate between the contact pieces is slightly floated from the under face of the lid unit 15 for the manufacturing line only by a gap S.
   Since the contact piece is supported by the elastic supporting plate between the contact pieces in a state where it is slightly floated from the attachment face, a thin plate is supported with a force which is normally not so strong. When a large shock is given from the outside, like a case where the thin plate supporting container is dropped by mistake, the gap S disappears, and the elastic supporting plate between the contact pieces comes into contact with the supporting face and strongly supports the contact pieces. In such a manner, a thin plate is protected from a strong shock.
(3) Although a semiconductor wafer is supported by the supporting pawls 97 in the above first embodiment, it may be supported by blocks. As shown in FIGS. 30 and 31, like the above embodiment, blocks 115 are disposed alternately in a state where two blocks 115 face each other. That is, four sets of blocks 115 are arranged while maintaining the intervals and are deviated from each other. Further, the contact surfaces 115A in a set of blocks 115 are set at 20° and 4° from the vertical line. The contact surface 115A on the side with which the semiconductor wafer comes in contact is set to 4°. By sandwiching the periphery of a semiconductor wafer with the blocks at the angle 4° each (8° by both sides), without deviating the semiconductor wafer, the semiconductor wafer can be supported with reliability.
   Alternately, the blocks may be provided as shown in FIGS. 32 and 33. The configuration is similar to that described with reference to FIGS. 28 and 29 and can produce actions and effects similar to the above.
(4) Although an example of using the lid unit for the thin plate supporting container in the manufacturing line has been described in the first embodiment, the lid unit for the thin plate supporting container can be also used for storage, transport, and the like. In this case as well, actions and effects similar to those of the above embodiment can be produced.
(5) Although two simple attaching/detaching mechanisms 32 are provided for the lid unit 15 for the manufacturing line in the first embodiment, the number of the simple attaching/detaching mechanisms 32 may be one or three or more in accordance with the standard or the like.
(6) Although the case of applying the lid unit for a thin plate supporting container to a container for housing semiconductor wafers has been described in the example, the lid unit can be applied not only to the container for housing semiconductor wafers but also to a container for housing other thin plates. In this case as well, actions and effects similar to those in the above example can be produced.
(7) In the example and the modification, the wafer presser as a thin plate presser for supporting a thin plate housed in a container body is applied to the thin plate supporting container 11 of the example. The invention is not limited to the thin plate supporting container 11 but can be also applied to thin plate supporting containers having other structures. In this case as well, actions and effects similar to those of the above example can be produced.
(8) Although the lid unit holder 100 is applied to the thin plate supporting container 11 in the example, the invention is not limited to the thin plate supporting container. The lid unit holder 100 can be also applied to thin plate supporting containers having the other structures. In this case as well, actions and effects similar to those of the above example can be produced.
(9) Although two contact pieces 124 of the wafer presser 121 are provided in the embodiment, three or more contact pieces 124 may be provided. In the case of providing three or more contact pieces 124, the connecting and supporting plate 125 and the supporting rib 126 are provided between the neighboring contact pieces 124. In this case as well, actions and effects similar to those in the above embodiment can be produced.
(10) In the embodiment, the horizontal plate 125C is supported by the supporting projection bar 131. Alternately, a supporting projection may be provided in the center of the horizontal plate 125C. In the case of providing the supporting projection, the supporting projection bar 131 may not be provided. In the case of providing the supporting projection bar 131, the supporting projection supports the horizontal plate 125C by being in contact with the supporting projection bar 131. In the case where the supporting projection bar 131 is not provided, the supporting projection supports the horizontal plate 125C by being in contact with the rear face of the lid unit 127.
   In the case where the supporting projection bar 131 is not provided, the height of the supporting projection in the center of the horizontal plate 125C is set so that the center portion is higher than both sides as in the second embodiment. In the case of providing the supporting projection bar 131, the height obtained by adding the supporting projection in the center portion of the horizontal plate 125C and the supporting projection bar 131 is set so that the center portion is higher than the both sides. In this case as well, actions and effects similar to those in the embodiment can be produced.
(11) Although the fitting groove 124A of the contact piece 124 is formed in a V shape in the embodiment, like the contact piece 94 in the example, supporting pieces disposed alternately may be provided for the contact piece 124. That is, the contact piece 124 of the embodiment may be constructed by, like the contact piece 94 of the first embodiment, the two blocks 96 and the alternately disposed supporting pawls 97 (supporting pieces). With the structure, the supporting pieces disposed alternately are in contact with the periphery of the semiconductor wafer 120, so that the semiconductor wafer 120 is supported with reliability. As a result, shake of the semiconductor wafer 120 caused by the vibrations from the outside can be minimized. In addition, the semiconductor wafer 120 can be prevented from being rotated more reliably.
(12) The structure for supporting the contact piece 124 of the wafer presser 121 is not limited to the structure of the embodiment but may be another structure. Any structure may be employed as long as the contact piece 124 positioned to the center side as compared with the contact pieces positioned on both sides can be disposed so as to be projected to the semiconductor wafer 120 side.
   For example, the elastic supporting plate 123 may be formed so as to dispose the contact piece 124 positioned to the center side as compared with the contact pieces 124 positioned on both sides so as to be projected to the semiconductor wafer 120 side. Any one of the elastic supporting plate 123 and the connecting and supporting plate 125 or both may be formed so as to dispose the contact piece 124 which is positioned to the center side as compared with the contact pieces 124 positioned on both sides so as to be projected to the semiconductor wafer 120 side.
(13) Although the connecting and supporting plate 125 is supported by the supporting ribs 126 in the embodiment, it can be supported by projections. Specifically, as shown in FIG. 44, the connecting and supporting plate 125 may be supported by a fitting projection 142 which is fit in a fitting hole 141 opened in the connecting and supporting plate 125, thereby preventing deviation of the connecting and supporting plate 125 along the rear surface of the lid unit while allowing fluctuations in the direction perpendicular to the rear surface of the lid unit. In this case as well, actions and effects similar to those of the embodiment can be produced.

## Claims

1. A lid unit for a thin plate supporting container (4) for closing a container body of a thin plate supporting container in which a plurality of thin plates are housed and which is carried, comprising
a thin plate presser (121) for supporting thin plates housed in the container body (11), wherein the thin plate presser (121) comprises:
two base-end supporting portions (122) fixed to a rear surface of the lid unit;
a plurality of contact pieces (124) which are disposed along the periphery of the thin plate and come into direct contact with the thin plate;
two elastic supporting plates (123) supported by the base-end supporting portions (122) and supporting an outer end of each of contact pieces (124) at both ends among the plurality of contact pieces (124);
a connecting and supporting plate (125) for connecting and supporting the contact pieces (124); and
**characterized by**
a supporting member (126) for preventing a deviation of the connecting and
supporting plate (125) along the rear surface of the lid unit (127) while permitting fluctuations in the direction perpendicular to the rear surface of the lid unit (127).

2. The lid unit for a thin plate supporting container (4) according to claim 1, wherein the supporting member (126) has supporting ribs (126) for supporting each of the connecting and supporting plates (125) so as not to be deviated along the rear surface of the lid unit (127).

3. The lid unit for a thin plate supporting container according to claim 1, wherein the supporting member (126) has a fitting projection(142) which is fit in a fitting hole (141) formed in the connecting and supporting plate (125), thereby preventing a deviation along the rear surface of the lid unit of the connecting and supporting plate (125) while permitting fluctuations in a direction perpendicular to the rear surface of the lid unit (127).

4. The lid unit for a thin plate supporting container (4) according to claim 1, wherein elastic force for supporting the contact piece (124) by the connecting and supporting plate (125) is stronger than elastic force for supporting the contact piece (124) by the elastic supporting plate (123).

## Patentansprüche

1. Deckeleinheit für einen Tragebehälter (4) für dünne Platten, mit der ein Behälterkörper eines Tragebehälters für dünne Platten verschlossen wird, in dem eine Vielzahl dünner Platten aufgenommen sind und der transportiert wird, wobei sie umfasst:
eine Einrichtung (121) zum Pressen dünner Platten, mit der in dem Behälterkörper (11) aufgenommene dünne Platten getragen werden, wobei die Einrichtung (121) zum Pressen dünner Platten umfasst:
zwei Trageabschnitte (122) am unteren Ende, die an einer hinteren Fläche der Deckeleinheit befestigt sind;
eine Vielzahl von Kontaktteilen (124), die am Umfang der dünnen Platte angeordnet sind und in direkten Kontakt mit der dünnen Platte kommen;
zwei elastische Trageplatten (123), die von den Trageabschnitten (122) am unteren Ende getragen werden und von der Vielzahl von Kontaktteilen (124) ein äußeres Ende jedes der Kontaktteile (124) an beiden Enden tragen;
eine Verbindungs-und-Trageplatte (125) zum Verbinden und Tragen der Kontaktteile (124); und
**gekennzeichnet durch**
ein Trageelement (126), mit dem eine Verschiebung der Verbindungs-und-Trageplatte (125) an der hinteren Fläche der Deckeleinheit (127) verhindert wird und gleichzeitig Schwankungen in der Richtung senkrecht zu der hinteren Fläche der Deckeleinheit (127) zugelassen werden.

2. Deckeleinheit für einen Tragebehälter (4) für dünne Platten nach Anspruch 1, wobei das Trageelement (126) Tragerippen (126) aufweist, mit denen jede der Verbindungs-und-Trageplatten (125) so getragen wird, dass sie an der hinteren Fläche der Deckeleinheit (127) nicht verschoben wird.

3. Deckeleinheit für einen Tragebehälter für dünne Platten nach Anspruch 1, wobei das Trageelement (126) einen Passvorsprung (142) aufweist, der in ein Passloch (141) eingepasst ist, das in der Verbindungs-und-Trageplatte (125) ausgebildet ist, um so eine Verschiebung der Verbindungs-und-Trageplatte (125) an der hinteren Fläche der Deckeleinheit zu verhindern und gleichzeitig Schwankungen in einer Richtung senkrecht zu der hinteren Fläche der Deckeleinheit (127) zuzulassen.

4. Deckeleinheit für einen Tragebehälter (4) für dünne Platten nach Anspruch 1, wobei elastische Kraft zum Tragen des Kontaktteils (124) mittels der Verbindungs-und-Trageplatte (125) stärker ist als elastische Kraft zum Tragen des Kontaktteils (124) mittels der elastischen Trageplatte (123).

## Revendications

1. Dispositif de couvercle pour un récipient de plaques minces (4), destiné à fermer le corps de récipient d'un récipient de plaques minces, dans lequel est logée une pluralité de plaques minces et qui est transporté, comprenant :
- un presseur de plaques minces (121) pour supporter les plaques minces logées dans le corps de récipient (11), dans lequel le presseur de plaques minces (121) comprend :
- deux parties de support d'extrémités de base (122) fixées à une surface arrière du dispositif de couvercle ;
- une pluralité de pièces de contact (124) disposées le long de la périphérie de la plaque mince et venant en contact direct avec la plaque mince ;
- deux plaques de support élastiques (123) supportées par les parties de support d'extrémités de base (122) et supportant une extrémité extérieure de chacune des pièces de contact (124) aux deux extrémités parmi la pluralité de pièces de contact (124) ;
- une plaque de support et de connexion (125) pour connecter et supporter les pièces de contact (124) ; et
- **caractérisé par** :
- un élément de support (126) pour empêcher une déviation de la plaque de support et de connexion (125) le long de la surface arrière du dispositif de couvercle (127) tout en autorisant des fluctuations dans la direction perpendiculaire à la surface arrière du dispositif de couvercle (127).

2. Dispositif de couvercle pour un récipient de plaques minces (4) selon la revendication 1, dans lequel l'élément de support (126) comporte des nervures de support (126) pour supporter chacune des plaques de support et de connexion (125) de façon à ne pas subir de déviation le long de la surface arrière du dispositif de couvercle (127).

3. Dispositif de couvercle pour un récipient de plaques minces selon la revendication 1, dans lequel l'élément de support (126) comporte une protubérance d'insertion (142) insérée dans un trou d'insertion (141) ménagé dans la plaque de support et de connexion (125), empêchant ainsi une déviation le long de la surface arrière du dispositif de couvercle de la plaque de support et de connexion (125) tout en autorisant des fluctuations dans une direction perpendiculaire à la surface arrière du dispositif de couvercle (127).

4. Dispositif de couvercle pour un récipient de plaques minces (4) selon la revendication 1, dans lequel une force d'élasticité pour supporter la pièce de contact (124) par la plaque de support et de connexion (125) est plus forte qu'une force d'élasticité pour supporter la pièce de contact (124) par la plaque de support élastique (123).
